# EUROPÄISCHE PATENTSCHRIFT

(11) **EP 4 144 994 B1**
(45) Veröffentlichungstag und Bekanntmachung des Hinweises auf die Patenterteilung: **07.05.2025**
(21) Anmeldenummer: 22213500.6
(22) Anmeldetag: 14.12.2022
(51) Int. Cl.: F04D 19/04, F04D 29/058, F16C 32/04, G01R 33/12, H01F 7/02, H01F 41/02

(54) **VORRICHTUNG UND VERFAHREN ZUM BEWERTEN EINES MAGNETLAGERS**
DEVICE AND METHOD FOR EVALUATING A MAGNETIC BEARING
DISPOSITIF ET PROCÉDÉ D'ÉVALUATION D'UN PALIER MAGNÉTIQUE

(43) Veröffentlichungstag der Anmeldung: 08.03.2023
(73) Patentinhaber: Pfeiffer Vacuum Technology AG, 35614 Asslar (DE)
(72) Erfinder: WIELSCH, Pascal, 35390 Gießen (DE); WIRTH, Adrian, 35619 Braunfels (DE); SIEBEN, Daniel, 35440 Linden (DE); KOCI, Bernd, 35641 Schöffengrund (DE)
(74) Vertreter: Manitz Finsterwald Patent- und Rechtsanwaltspartnerschaft mbB

(56) Entgegenhaltungen:
- EP-A2- 3 708 843
- DE-A1- 10 321 925
- US-A1- 2014 035 412

## Beschreibung

Die Erfindung betrifft eine Vorrichtung und ein Verfahren zum Bewerten eines Magnetlagers. Ferner betrifft die Erfindung eine Vakuumpumpe, deren Magnetlager unter Verwendung dieser Vorrichtung und/oder dieses Verfahrens optimiert ist.

In Vakuumpumpen und insbesondere in Turbomolekularpumpen werden üblicherweise Magnetlager verwendet, um einen schnell drehenden Rotor der Pumpe an einem Stator zu lagern. Turbomolekularpumpen weisen häufig eine Hybridlagerung auf, bei welcher der Rotor durch eine Kombination aus einem Wälzlager auf der Niederdruckseite der Pumpe und einem Magnetlager mit Permanentmagneten getragen wird, das auf der Hochvakuumseite der Pumpe angeordnet ist. Ein solches Permanentmagnetlager umfasst einen Statorteil und einen Rotorteil mit jeweils mehreren Paaren von Ringmagneten. Die Ringmagnete sind in axialer Richtung magnetisiert, d. h. parallel zu einer Drehachse des Rotors der Turbomolekularpumpe, konzentrisch zueinander angeordnet und repulsiv aufgebaut. Dies bedeutet, dass die Magnetisierung der Ringmagnete jeweils im Statorteil und im Rotorteil des Magnetlagers bei aufeinanderfolgenden Ringen entgegengesetzt zueinander ausgerichtet ist.

Der Rotor einer Vakuumpumpe weist wie jedes rotierende Objekt stets eine gewisse Restunwucht auf, die zu Kräften in radialer Richtung führt. Diese Kräfte können über das Wälzlager und das Permanentmagnetlager der Vakuumpumpe auf deren Gehäuse übertragen werden und zu Vibrationen sowie Geräuschen führen. Bestimmte Anwendungen wie beispielsweise Elektronenmikroskope oder Ionen-Mobilitäts-Spektrometer erfordern jedoch ein sehr geringes Vibrationsniveau der verwendeten Turbomolekularpumpe.

Daher ist es für solche und andere Anwendungen erforderlich, Vibrationen und Geräusche der Turbomolekularpumpe zu minimieren. Dies kann einerseits dadurch erfolgen, dass die Restunwucht des Rotors durch ein optimiertes Auswuchten minimiert wird, und andererseits dadurch, dass die Lagerung des Rotors bezüglich des Stators bzw. am Gehäuse der Vakuumpumpe analysiert und verbessert wird. Die vorliegende Anmeldung ist auf eine solche Analyse und Verbesserung eines Magnetlagers für einen Rotor einer Vakuumpumpe gerichtet.

Ein ideal magnetisierter Ringmagnet weist einerseits eine Magnetisierungsachse auf, die exakt der Symmetrieachse des Ringmagneten bzw. des zu lagernden Rotors entspricht, und andererseits ist das magnetische Material eines solchen idealen Ringmagneten perfekt homogen. In der Realität weicht die Magnetisierung eines Ringmagneten jedoch aufgrund verschiedener Faktoren bzw. Magnetisierungseigenschaften von der Magnetisierung eines idealen Ringmagneten ab. Beispielsweise kann ein Winkelfehler auftreten, bei dem die magnetische Vorzugsrichtung des Ringmagneten von dessen Symmetrieachse bzw. der Symmetrieachse des Rotors abweicht, und das magnetische Material des Ringmagneten kann eine gewisse Inhomogenität aufweisen. Darüber hinaus kann entlang des Umfangs des Ringmagneten eine rotationssymmetrische Verkippung der tatsächlichen Magnetisierung auftreten, was als Nord/Süd-Asymmetrie bezeichnet wird. Außerdem kann ein Ringmagnet mechanische Abweichungen von der Form eines idealen Ringmagneten aufweisen, beispielsweise bezüglich der gewünschten Abmessungen sowie durch Mikrorisse oder Abplatzer in bzw. am jeweiligen Ringmagnet.

Durch die individuellen Magnetisierungseigenschaften der Ringmagnete entstehen in dem Permanentlager insgesamt zusätzliche Kräfte, insbesondere radiale Kräfte. Im Falle der radialen Kräfte führt die schnelle Drehung des Rotors einer Turbomolekularpumpe zu einer harmonisch bzw. periodisch umlaufenden Radialkraft, die auch als Magnetlagerfehler bezeichnet wird. Der Magnetlagerfehler ist also ebenso wie diese Radialkraft ein Vektor mit Betrag und Winkelrichtung. Ein solcher Magnetlagerfehler beeinflusst die Laufeigenschaften des Rotors innerhalb der Turbomolekularpumpe, insbesondere bei niedrigen Drehzahlen.

Zusätzlich kann eine Erwärmung des Rotors während des Betriebs der Turbomolekularpumpe eine axiale Verschiebung zwischen den Ringmagneten des Rotors und den Ringmagneten des Stators hervorrufen und zu einer zusätzlichen Veränderung der axialen Kräfte im Rotor führen. Es hat sich gezeigt, dass die umlaufende Radialkraft und der entsprechende Magnetlagerfehler eine starke Abhängigkeit von einer solchen axialen Verschiebung aufweisen. Dies kann den Hochlauf des Rotors der Turbomolekularpumpe beeinflussen, und die Pumpe kann während ihres Betriebs vibratorisch und akustisch auffällig sein und die vorstehend genannten Anwendungen stören. Darüber hinaus kann ein erhöhtes magnetisches Streufeld durch eine solche Turbomolekularpumpe hervorgerufen werden, welches solche Anwendungen ebenfalls stört, die stattdessen ein möglichst geringes Streufeld benötigen.

Aus der US 2014/0035412 A1 sind eine Vorrichtung und ein Verfahren mit den Merkmalen gemäß dem jeweiligen Oberbegriff des Anspruchs 1 bzw. 6 bekannt.

Die DE 103 21 925 A1 beschreibt eine Vorrichtung und ein Verfahren mit Merkmalen gemäß einer verwandten Technologie.

Ferner ist in der EP 3 708 843 A2 ein Verfahren zur Herstellung eines Elektromotors oder eines Vakuumgeräts mit einem solchen beschrieben, bei welchem ein Magnetfeld eines Permanentmagneten des Elektromotors erfasst und derart optimiert wird, dass eine Abweichung in der Symmetrie und/oder eine magnetische Radialkraft zwischen einem Rotor und einem Stator des Elektromotors möglichst gering ist.

Eine Aufgabe der Erfindung besteht darin, eine Vorrichtung und ein Verfahren zu schaffen, die eine Bewertung eines Magnetlagers ermöglichen, um dadurch dessen Magnetlagerfehler und/oder dessen magnetisches Streufeld zur Optimierung des Magnetlagers verringern zu können.

Diese Aufgabe wird durch eine Vorrichtung und ein Verfahren mit den Merkmalen der unabhängigen Ansprüche gelöst. Vorteilhafte Weiterbildungen der Erfindung sind in den Unteransprüchen, der Beschreibung und den Zeichnungen angegeben.

Die Vorrichtung ist zum Bewerten eines Magnetlagers vorgesehen, insbesondere einer Turbomolekularpumpe. Das Magnetlager weist mehrere Magnetelemente auf, um einen Rotor an einem Stator drehbar zu lagern. Die Vorrichtung umfasst eine Messeinrichtung, die ausgebildet ist, um Messwerte der magnetischen Feldstärke an mehreren vorbestimmten Positionen eines jeweiligen der mehreren Magnetelemente zu erfassen, und eine Auswertungseinrichtung, die mit der Messeinrichtung kommunikativ verbunden ist.

Die Auswertungseinrichtung ist ausgebildet, um für jedes der Magnetelemente die von der Messeinrichtung erfassten Messwerte der magnetischen Feldstärke zu empfangen und anhand der Messwerte der magnetischen Feldstärke Magnetisierungseigenschaften für jedes der Magnetelemente zu ermitteln. Die Auswertungseinrichtung ist ferner ausgebildet, um vorgegebene Geometriedaten des Magnetlagers zu empfangen und um anhand der vorgegebenen Geometriedaten sowie anhand der Magnetisierungseigenschaften jedes der Magnetelemente zumindest eine resultierende Kraft zu ermitteln, welche die Magnetelemente auf den Rotor ausüben. Ferner ist die Auswertungseinrichtung ausgebildet, um anhand der resultierenden Kraft eine Bewertung des Magnetlagers zu ermitteln und auszugeben.

Die Erfassung der magnetischen Feldstärke an mehreren vorbestimmten Positionen der jeweiligen Magnetelemente kann umfassen, dass die magnetische Feldstärke beispielsweise entlang des jeweiligen Umfangs der Magnetelemente an gleichmäßig beabstandeten Messpunkten erfasst wird. Zusätzlich kann die magnetische Feldstärke für Ringsegmente des jeweiligen Magnetelements, die sich beispielsweise über einen Winkel von 45 ° oder 90 ° erstrecken können, z.B. durch eine Mittelung über diejenigen Messpunkte zusammengefasst werden, die sich innerhalb des jeweiligen Ringsegments befinden. Die Messeinrichtung kann beispielsweise eine oder mehrere Hallsonden umfassen.

Die Magnetisierungseigenschaften des jeweiligen Magnetelements können durch einen oder mehrere Magnetisierungsvektoren repräsentiert werden, die entweder für Segmente oder Abschnitte des jeweiligen Magnetelements oder als resultierender Vektor für das gesamte Magnetelement ermittelt werden. Die Magnetisierungseigenschaften können ferner Abweichungen von einer idealen Magnetisierung des jeweiligen Magnetelements umfassen bzw. darstellen. Diese Abweichungen von der idealen Magnetisierung können einen Winkelfehler des resultierenden Magnetisierungsvektors bezüglich einer Symmetrieachse des Magnetelements, eine Inhomogenität der Magnetisierung und eine Nord/Süd-Asymmetrie umfassen. Die Nord/Süd-Asymmetrie wird dadurch hervorgerufen, dass entlang des Umfangs des jeweiligen Magnetelements die jeweils lokale Magnetisierungsrichtung gegenüber einer Symmetrieachse des Magnetelements geneigt ist. Die Abweichungen von der idealen Magnetisierung können auch dadurch hervorgerufen werden, dass eine betragsmäßige lokale Abweichung bezogen auf den mittleren Wert der Magnetisierung des gesamten Magnetlagers auftritt, wobei die lokale Magnetisierung jeweils durch einen ortsabhängigen Magnetisierungsvektor beschrieben wird. Die Abweichungen von der idealen Magnetisierung können ferner durch mechanische Defekte des jeweiligen Magnetelements hervorgerufen sein, die Abweichungen von vorgegebenen Abmessungen des Magnetelements, Mikrorisse und Abplatzer umfassen können.

Die vorgegebenen Geometriedaten des Magnetlagers können die Abmessungen der jeweiligen Magnetelemente des Magnetlagers, die Anzahl der Magnetelemente im Magnetlager und deren jeweilige Abstände zueinander umfassen. Um die zumindest eine resultierende Kraft zu ermitteln, welche die Magnetelemente auf den Rotor ausüben, kann eine Koeffizientenmatrix gebildet werden, die den Einfluss der jeweiligen Magnetisierungseigenschaften der im Magnetlager vorhandenen Magnetelemente auf die jeweiligen Kräfte beschreibt, die von dem jeweiligen Magnetelement ausgeübt werden. Die resultierende Kraft kann durch eine vektorielle Addition dieser einzelnen Kräfte der jeweiligen Magnetelemente ermittelt werden.

Das erfindungsgemäße Verfahren gestattet somit eine Voraussage der zumindest einen resultierenden Kraft, welche die Magnetelemente auf den Rotor ausüben, bevor das Magnetlager aus den mehreren Magnetelementen unter Verwendung der vorgegebenen Geometriedaten zusammengesetzt wird. Die Voraussage der resultierenden Kraft ermöglicht die Bewertung des aus den mehreren Magnetelementen zusammengesetzten Magnetlagers, für das diese resultierende Kraft beispielsweise möglichst gering sein soll, um dadurch eine optimale Lagerung des Rotors an dem Stator zu erreichen. Die Vorrichtung zeichnet sich folglich dadurch aus, dass sie durch die Vorhersage der resultierenden Kraft und die darauf basierende Bewertung des Magnetlagers die Grundlage für dessen Optimierung bereitstellt.

Die Auswertungseinrichtung ist ferner ausgebildet sein, um die zumindest eine resultierende Kraft in Abhängigkeit von einer axialen Verschiebung des Rotors bezüglich des Stators zu ermitteln. Es hat sich gezeigt, dass für optimale Laufeigenschaften eines Magnetlagers, beispielsweise in einer Turbomolekularpumpe, die vorausgesagte resultierende Kraft eine möglichst geringe Abhängigkeit von der axialen Verschiebung des Rotors bezüglich des Stators aufweisen sollte. Daher stellt die Ermittlung der resultierenden Kraft in Abhängigkeit von der axialen Verschiebung des Rotors bezüglich des Stators ein weiteres Kriterium zur Bewertung des Magnetlagers dar. Dadurch kann bei der Optimierung des Magnetlagers berücksichtigt werden, dass die resultierende Kraft eine möglichst geringe Abhängigkeit von der axialen Verschiebung zwischen Rotor und Stator aufweisen sollte, und die Magnetelemente für das Magnetlager können entsprechend ausgewählt oder ausgestaltet werden. Zusätzlich können die vorgegebenen Geometriedaten des Magnetlagers angepasst werden, um eine möglichst geringe Abhängigkeit der resultierenden Kraft von der axialen Verschiebung zwischen Rotor und Stator zu erreichen.

Die Auswertungseinrichtung kann ferner ausgebildet sein, um eine Koeffizientenmatrix zu bilden, welche die Abhängigkeit einzelner Kräfte, die die jeweiligen Magnetelemente auf den Rotor ausüben, von den jeweiligen Magnetisierungseigenschaften der einzelnen Magnetelemente beschreibt, und um die resultierende Kraft durch eine vektorielle Addition der einzelnen Kräfte der jeweiligen Magnetelemente zu ermitteln. Die Koeffizientenmatrix kann folglich dazu dienen, die Verbindung zwischen den jeweiligen Magnetisierungseigenschaften der einzelnen Magnetelemente, die aus einer jeweiligen Messung der magnetischen Feldstärke mittels der Messeinrichtung resultieren, und der resultierenden Kraft herzustellen. Die Verwendung der Koeffizientenmatrix kann ferner den Austausch eines einzelnen oder mehrerer Magnetelemente erleichtern, wenn das Magnetlager mittels einer iterativen Anwendung der Vorrichtung bezüglich der resultierenden Kraft optimiert werden soll.

Die Auswertungseinrichtung kann ferner ausgebildet sein, um einen Magnetlagerfehler anhand der zumindest einen resultierenden Kraft und/oder ein magnetisches Streufeld des Magnetlagers anhand der Magnetisierungseigenschaften jedes der Magnetelemente und anhand der vorgegebenen Geometriedaten des Magnetlagers zu ermitteln und auszugeben. Wie eingangs bereits erläutert, ist der Magnetlagerfehler durch eine harmonisch umlaufende Radialkraft gegeben, die aus den Magnetisierungseigenschaften der einzelnen Magnetelemente resultiert und durch die Drehung des Rotors hervorgerufen wird. Somit kann der Magnetlagerfehler aus der zumindest einen resultierenden Kraft abgeleitet werden und ist wie diese ein Vektor mit Betrag und Winkelrichtung bzw. Winkellage. Der Magnetlagerfehler und das magnetische Streufeld des Magnetlagers können alternative oder zusätzliche Kriterien zur Bewertung und Optimierung des Magnetlagers darstellen. Ob der Magnetlagerfehler, das magnetische Streufeld des Magnetlagers oder beide Größen zur Bewertung des Magnetlagers herangezogen werden, kann von dem jeweiligen Umfeld abhängen, in welchem das Magnetlager oder beispielsweise eine Turbomolekularpumpe, die ein solches umfasst, eingesetzt werden soll. Es kann beispielsweise von dem Verwendungszweck einer Turbomolekularpumpe abhängen, ob deren Magnetlager beispielsweise bezüglich eines möglichst geringen Magnetlagerfehlers oder bezüglich eines möglichst geringen magnetischen Streufelds des Magnetlagers optimiert wird.

Die Vorrichtung kann ferner eine Optimierungseinrichtung umfassen, die ausgebildet ist, um die vorgegebenen Geometriedaten des Magnetlagers und/oder Parameter der Magnetelemente derart zu variieren, dass der Magnetlagerfehler und/oder das magnetische Streufeld des Magnetlagers eine vorbestimmte Optimierungsbedingung erfüllen. Da die Auswertungseinrichtung eine Voraussage für den Magnetlagerfehler und/oder das Streufeld des gesamten Magnetlagers ausgeben kann, kann zusätzlich vorgesehen sein, dass die Vorrichtung mittels der Optimierungseinrichtung Informationen ermittelt und bereitstellt, wie die vorgegebenen Geometriedaten des Magnetlagers und/oder die Parameter oder Eigenschaften der Magnetelemente zu verändern sind, um das Magnetlager zu verbessern bzw. zu optimieren, und zwar im Hinblick auf den Magnetlagerfehler und/oder das magnetische Streufeld.

Die Optimierungsbedingung kann beispielsweise umfassen, dass der Magnetlagerfehler und/oder das magnetische Streufeld bezüglich des Betrags möglichst gering sein sollen. Die Variation der Geometriedaten des Magnetlagers kann beispielsweise umfassen, dass die Anzahl der Magnetelemente, die Abmessungen der Magnetelemente und/oder der Abstand zwischen den Magnetelementen innerhalb des Magnetlagers verändert werden, um anschließend erneut zumindest eine resultierende Kraft bzw. erneut den Magnetlagerfehler und das magnetische Streufeld zu ermitteln und diese gemäß einem iterativen Vorgang mit den zuvor ermittelten Werten der Kraft, des Magnetlagerfehlers und/oder des magnetischen Streufelds zu vergleichen.

Auf ähnliche Weise können die Parameter der Magnetelemente verändert werden, d. h. beispielsweise durch Veränderung von deren Magnetisierung und/oder Abmessungen. Zusätzlich kann vorgesehen sein, dass ein oder mehrere Magnetelemente durch andere Magnetelemente ersetzt werden, für welche die Messeinrichtung zuvor ebenfalls Messwerte der magnetischen Feldstärke an mehreren vorbestimmten Positionen erfasst hat. Auf diese Weise kann insgesamt ein Magnetlager konfiguriert werden, das für eine Gruppe bereitgestellter Magnetelemente und deren Datenbasis bezüglich des Magnetlagerfehlers und/oder des Streufelds optimiert ist.

Gemäß einer weiteren Ausführungsform kann das Magnetlager als ein Permanentmagnetlager ausgebildet sein, bei welchem die Magnetelemente eine vorgegebene Anzahl von Ringmagneten umfassen. Die vorgegebene Anzahl von Ringmagneten kann innere und äußere Ringmagnete umfassen, die jeweils dem Rotor oder dem Stator beispielsweise innerhalb einer Turbomolekularpumpe zugeordnet sind. Die Verwendung eines Permanentmagnetlagers mit Ringmagnet kann eine kostengünstige und robuste Ausgestaltung des Magnetlagers ermöglichen.

Für ein solches Permanentmagnetlager kann die Messeinrichtung ferner ausgebildet sein, um die magnetische Feldstärke entlang eines Umfangs jedes einzelnen der Ringmagnete des Magnetlagers zu ermitteln. Für eine solche Ermittlung können Hallsonden verwendet werden. Entlang des Umfangs der jeweiligen Ringmagnete kann die magnetische Feldstärke für eine vordefinierte Anzahl von Messpunkten ermittelt werden, und die magnetische Feldstärke kann für Segmente der Ringmagnete jeweils zusammengefasst werden, beispielsweise durch Mittelung über die in dem jeweiligen Segment vorhandenen Messpunkte. Die Segmente können sich beispielsweise über einen Winkel von 45 ° oder 90 ° erstrecken. Durch diese Zusammenfassung von Messdaten für die magnetische Feldstärke kann die Berechnungszeit verkürzt werden, welche die Vorrichtung für die Ermittlung der Ergebnisse benötigt, d. h. für die Ermittlung der zumindest einen resultierenden Kraft, des Magnetlagerfehlers und/oder des magnetischen Streufelds.

Gemäß einem weiteren Aspekt ist ferner ein Verfahren zum Bewerten eines Magnetlagers vorgesehen, insbesondere einer Turbomolekularpumpe, welches mehrere Magnetelemente aufweist, um einen Rotor an einem Stator drehbar zu lagern. Das Verfahren umfasst, dass a) Messwerte der magnetischen Feldstärke an mehreren vorbestimmten Positionen eines jeweiligen der mehreren Magnetelemente erfasst werden, b) Magnetisierungseigenschaften für jedes der Magnetelemente, beispielsweise gemittelt für Segmente von Ringmagneten, anhand der Messwerte der magnetischen Feldstärke ermittelt werden, c) vorgegebene Geometriedaten des Magnetlagers empfangen werden, d) anhand der Magnetisierungseigenschaften jedes der Magnetelemente und anhand der vorgegebenen Geometriedaten des Magnetlagers zumindest eine resultierende Kraft ermittelt wird, welche die Magnetelemente auf den Rotor ausüben, und e) eine Bewertung des Magnetlagers anhand der resultierenden Kraft ermittelt und ausgegeben wird.

Die vorstehend beschriebene Vorrichtung ist folglich dafür vorgesehen, die Schritte a) bis e) des Verfahrens mittels der Messeinrichtung und der Auswertungseinrichtung auszuführen. Die vorstehenden Ausführungen zu der erfindungsgemäßen Vorrichtung gelten daher sinngemäß auch für das erfindungsgemäße Verfahren, insbesondere hinsichtlich der Offenbarung, der Vorteile und der bevorzugten Ausführungsformen.

Die zumindest eine resultierende Kraft wird in Abhängigkeit von einer axialen Verschiebung des Rotors bezüglich des Stators ermittelt. Es kann eine Koeffizientenmatrix gebildet werden, welche die Abhängigkeit einzelner Kräfte, die die jeweiligen Magnetelemente auf den Rotor ausüben, von den jeweiligen Magnetisierungseigenschaften der einzelnen Magnetelemente beschreibt. Die resultierende Kraft kann durch eine vektorielle Addition der einzelnen Kräfte der jeweiligen Magnetelemente ermittelt werden. Ferner kann ein Magnetlagerfehler anhand der zumindest einen resultierenden Kraft und/oder ein magnetisches Streufeld des Magnetlagers anhand der Magnetisierungseigenschaften jedes der Magnetelemente und anhand der vorgegebenen Geometriedaten des Magnetlagers ermittelt werden.

Die vorgegebenen Geometriedaten des Magnetlagers und/oder Parameter der Magnetelemente können darüber hinaus derart variiert werden, dass der Magnetlagerfehler und/oder das magnetische Streufeld des Magnetlagers eine vorbestimmte Optimierungsbedingung erfüllen.

Gemäß einer weiteren Ausführungsform kann das Magnetlager als ein Permanentmagnetlager ausgebildet sein, und die Magnetelemente können eine vorgegebene Anzahl N von Ringmagneten umfassen. Das vorstehend genannte Variieren der Parameter der Magnetelemente kann umfassen, dass eine vorbestimmte Vielzahl M von Ringmagneten bereitgestellt wird, die größer als die vorgegebene Anzahl N der Ringmagnete ist, die zum Bilden bzw. Zusammensetzen des Magnetlagers erforderlich sind. Eine Kombination von N Ringmagneten kann aus der vorbestimmten Vielzahl M der Ringmagnete ausgewählt werden, wobei für diese Kombination der Magnetlagerfehler und/oder das magnetische Streufeld des Magnetlagers die vorbestimmte Optimierungsbedingung erfüllen.

Die Vielzahl M kann beispielsweise 50 betragen, sodass die Ringmagnete für das Magnetlager aus einem Puffer oder Vorrat von 50 Ringmagneten ausgewählt werden. Die vorgegebene Anzahl N von Ringmagneten zum Bilden bzw. Zusammensetzen des Magnetlagers kann für eine Turbomolekularpumpe beispielsweise 10 betragen, wobei 5 Ringmagnete für den Rotor und weitere 5 Ringmagnete für den Stator vorgesehen sein können. Es ist jedoch auch möglich, dass beispielsweise 5 Ringmagnete zunächst fest für den Stator ausgewählt werden und von den verbleibenden Ringmagneten im Puffer eine Kombination von 5 Ringmagneten für den Rotor gemäß dem Verfahren derart ausgewählt wird, dass der Magnetlagerfehler und/oder das magnetische Streufeld des Magnetlagers insgesamt, d.h. für das zusammengesetzte Magnetlager, die vorbestimmte Optimierungsbedingung erfüllen, gemäß welcher beispielsweise beides minimiert wird. Das Verfahren gestattet folglich in beiden Fällen, für die M Ringmagnete des Puffers die beste Kombination von N Ringmagneten zu ermitteln.

Gemäß einer weiteren Ausführungsform kann für die vorbestimmte Vielzahl M von Ringmagneten jede mögliche Kombination von N Ringmagneten zum Bilden des Magnetlagers ermittelt werden. Für jede dieser ermittelten Kombinationen von N Ringmagneten können die Schritte a) bis e) des Verfahrens ausgeführt werden, um für die jeweilige Kombination den jeweiligen Magnetlagerfehler anhand der jeweiligen zumindest einen resultierenden Kraft und/oder ein jeweiliges magnetisches Streufeld des Magnetlagers anhand der Magnetisierungseigenschaften der N Ringmagnete der jeweiligen Kombination und anhand der vorgegebenen Geometriedaten des Magnetlagers zu ermitteln. Schließlich kann diejenige Kombination von N Ringmagneten ausgewählt werden, für die der jeweilige Magnetlagerfehler und/oder das jeweilige magnetische Streufeld die vorbestimmte Optimierungsbedingung am besten erfüllen.

Die möglichen Kombinationen von N Ringmagneten zum Bilden des Magnetlagers können als Permutationen ohne Wiederholung ermittelt werden. Zusätzlich kann die Reihenfolge der Ringmagnete im Magnetlager berücksichtigt werden. Die Schritte a) bis e) des Verfahrens zur Vorhersage der zumindest einen resultierenden Kraft im Rotor kann folglich für jede der ermittelten Kombinationen iterativ ausgeführt werden. Durch das Auswählen der "besten" Kombination, für die der Magnetlagerfehler und/oder das magnetische Streufeld der vorbestimmten Optimierungsbedingung am nächsten kommen, kann sichergestellt werden, dass für die Vielzahl M von Ringmagneten tatsächlich keine bessere Kombination von N Ringmagneten entsprechend der vorbestimmten Optimierungsbedingung gefunden werden kann.

Die vorbestimmte Optimierungsbedingung kann umfassen, dass der Magnetlagerfehler und/oder das magnetische Streufeld entlang einer axialen Richtung des Magnetlagers im Wesentlichen konstant bleibt. "Im Wesentlichen konstant" bedeutet im vorliegenden Zusammenhang, dass eine maximale relative Abweichung für den Betrag und/oder die Winkelrichtung bzw. Winkellage des Magnetlagerfehlers und/oder des magnetischen Streufelds entlang der axialen Richtung des Magnetlagers nicht überschritten wird und beispielsweise maximal 1-5 % beträgt. Die Optimierungsbedingung gibt folglich vor, dass sich sowohl der Betrag als auch die Winkellage bzw. Phase des Magnetlagerfehlers entlang der axialen Richtung nur geringfügig ändern dürfen. Die vorbestimmte Optimierungsbedingung mit möglichst konstantem Magnetlagerfehler und/oder Streufeld kann daher bewirken, dass der Magnetlagerfehler und/oder das magnetische Streufeld in der axialen Richtung einen möglichst flachen Verlauf aufweisen. Bei Turbomolekularpumpen hat sich beispielsweise gezeigt, dass ein solcher flacher Verlauf des Magnetlagerfehlers bzw. der Radialkraft ein optimiertes und ruhiges Laufverhalten des Magnetlagers bzw. des Rotors der Turbomolekularpumpe bewirken kann.

Alternativ oder zusätzlich kann die vorbestimmte Optimierungsbedingung umfassen, dass der jeweilige Betrag des Magnetlagerfehlers und/oder des magnetischen Streufelds kleiner als ein vorbestimmter Schwellenwert ist. Gemäß dieser alternativen Optimierungsbedingung soll folglich ein möglichst geringer Magnetlagerfehler und/oder ein möglichst geringes Streufeld erreicht werden. Dies kann beispielsweise für die Verwendung des Magnetlagers vorgegeben sein, z. B. für eine Turbomolekularpumpe, die in einem bestimmten Umfeld verwendet werden soll.

Gemäß einem weiteren Aspekt ist eine Vakuumpumpe vorgesehen, bei der es sich insbesondere um eine Turbomolekularpumpe handelt. Die Vakuumpumpe weist ein Permanentmagnetlager mit N Ringmagneten auf, die gemäß dem vorstehend beschriebenen Verfahren aus einer vorbestimmten Vielzahl M von Ringmagneten derart ausgewählt sind, dass der Magnetlagerfehler und/oder das magnetische Streufeld des Permanentmagnetlagers eine vorbestimmte Optimierungsbedingung erfüllen. Die vorbestimmte Optimierungsbedingung kann umfassen, dass der Magnetlagerfehler und/oder das magnetische Streufeld entlang einer axialen Richtung oder bei einer Verschiebung entlang der axialen Richtung des Magnetlagers im Wesentlichen konstant bleibt und/oder dass der jeweilige Betrag des Magnetlagerfehlers und/oder des magnetischen Streufelds kleiner als ein vorbestimmter Schwellenwert ist.

Nachfolgend wird die Erfindung beispielhaft anhand vorteilhafter Ausführungsformen unter Bezugnahme auf die beigefügten Figuren beschrieben. Es zeigen, jeweils schematisch:
- Fig. 1: eine perspektivische Ansicht einer Turbomolekularpumpe,
- Fig. 2: eine Ansicht der Unterseite der Turbomolekularpumpe von Fig. 1,
- Fig. 3: einen Querschnitt der Turbomolekularpumpe längs der in Fig. 2 gezeigten Schnittlinie A-A,
- Fig. 4: eine Querschnittsansicht der Turbomolekularpumpe längs der in Fig. 2 gezeigten Schnittlinie B-B,
- Fig. 5: eine Querschnittsansicht der Turbomolekularpumpe längs der in Fig. 2 gezeigten Schnittlinie C-C,
- Fig. 6: eine Veranschaulichung unterschiedlicher Magnetisierungseigenschaften von Ringmagneten eines Permanentmagnetlagers,
- Fig. 7: ein Blockdiagramm einer Vorrichtung zum Bewerten eines Magnetlagers,
- Fig. 8: ein Blockdiagramm eines Algorithmus, der von der Vorrichtung zum Bewerten des Magnetlagers ausgeführt wird,
- Fig. 9: beispielhafte Diagramme für den Verlauf des Magnetlagerfehlers mit der axialen Verschiebung zwischen Rotor und Stator für ein nicht-optimiertes und für ein optimiertes Permanentmagnetlager und
- Fig. 10: Verfahrensschritte zum Optimieren eines Permanentmagnetlagers.

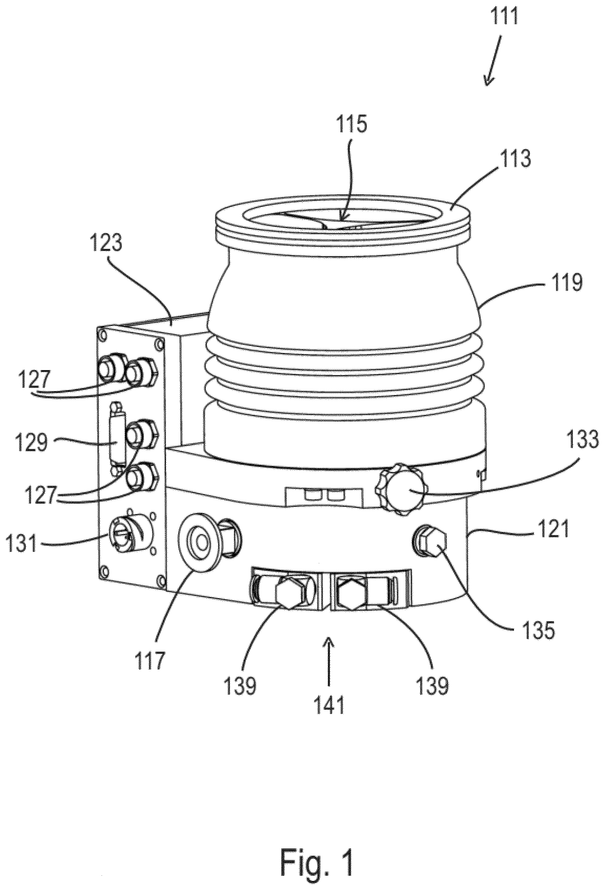

Die in Fig. 1 gezeigte Turbomolekularpumpe 111 umfasst einen von einem Einlassflansch 113 umgebenen Pumpeneinlass 115, an welchen in an sich bekannter Weise ein nicht dargestellter Rezipient angeschlossen werden kann. Das Gas aus dem Rezipienten kann über den Pumpeneinlass 115 aus dem Rezipienten gesaugt und durch die Pumpe hindurch zu einem Pumpenauslass 117 gefördert werden, an den eine Vorvakuumpumpe, wie etwa eine Drehschieberpumpe, angeschlossen sein kann.

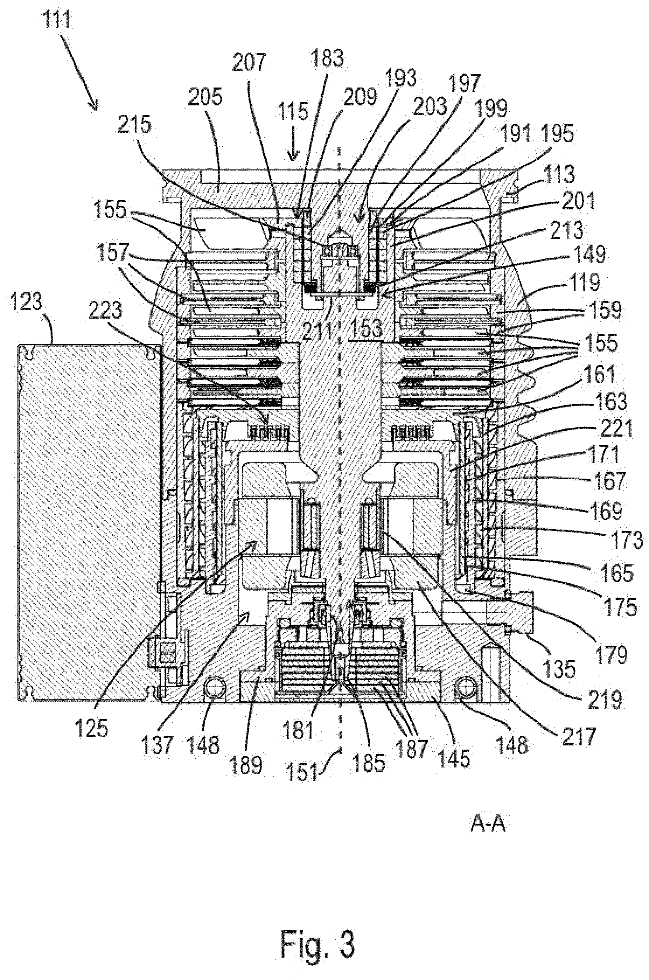

Der Einlassflansch 113 bildet bei der Ausrichtung der Vakuumpumpe gemäß Fig. 1 das obere Ende des Gehäuses 119 der Vakuumpumpe 111. Das Gehäuse 119 umfasst ein Unterteil 121, an welchem seitlich ein Elektronikgehäuse 123 angeordnet ist. In dem Elektronikgehäuse 123 sind elektrische und/oder elektronische Komponenten der Vakuumpumpe 111 untergebracht, z.B. zum Betreiben eines in der Vakuumpumpe angeordneten Elektromotors 125 (vgl. auch Fig. 3). Am Elektronikgehäuse 123 sind mehrere Anschlüsse 127 für Zubehör vorgesehen. Außerdem sind eine Datenschnittstelle 129, z.B. gemäß dem RS485-Standard, und ein Stromversorgungsanschluss 131 am Elektronikgehäuse 123 angeordnet.

Es existieren auch Turbomolekularpumpen, die kein derartiges angebrachtes Elektronikgehäuse aufweisen, sondern an eine externe Antriebselektronik angeschlossen werden.

Am Gehäuse 119 der Turbomolekularpumpe 111 ist ein Fluteinlass 133, insbesondere in Form eines Flutventils, vorgesehen, über den die Vakuumpumpe 111 geflutet werden kann. Im Bereich des Unterteils 121 ist ferner noch ein Sperrgasanschluss 135, der auch als Spülgasanschluss bezeichnet wird, angeordnet, über welchen Spülgas zum Schutz des Elektromotors 125 (siehe z.B. Fig. 3) vor dem von der Pumpe geförderten Gas in den Motorraum 137, in welchem der Elektromotor 125 in der Vakuumpumpe 111 untergebracht ist, eingelassen werden kann. Im Unterteil 121 sind ferner noch zwei Kühlmittelanschlüsse 139 angeordnet, wobei einer der Kühlmittelanschlüsse als Einlass und der andere Kühlmittelanschluss als Auslass für Kühlmittel vorgesehen ist, das zu Kühlzwecken in die Vakuumpumpe geleitet werden kann. Andere existierende Turbomolekularvakuumpumpen (nicht dargestellt) werden ausschließlich mit Luftkühlung betrieben.

Die untere Seite 141 der Vakuumpumpe kann als Standfläche dienen, sodass die Vakuumpumpe 111 auf der Unterseite 141 stehend betrieben werden kann. Die Vakuumpumpe 111 kann aber auch über den Einlassflansch 113 an einem Rezipienten befestigt werden und somit gewissermaßen hängend betrieben werden. Außerdem kann die Vakuumpumpe 111 so gestaltet sein, dass sie auch in Betrieb genommen werden kann, wenn sie auf andere Weise ausgerichtet ist als in Fig. 1 gezeigt ist. Es lassen sich auch Ausführungsformen der Vakuumpumpe realisieren, bei der die Unterseite 141 nicht nach unten, sondern zur Seite gewandt oder nach oben gerichtet angeordnet werden kann. Grundsätzlich sind dabei beliebige Winkel möglich.

Andere existierende Turbomolekularvakuumpumpen (nicht dargestellt), die insbesondere größer sind als die hier dargestellte Pumpe, können nicht stehend betrieben werden.

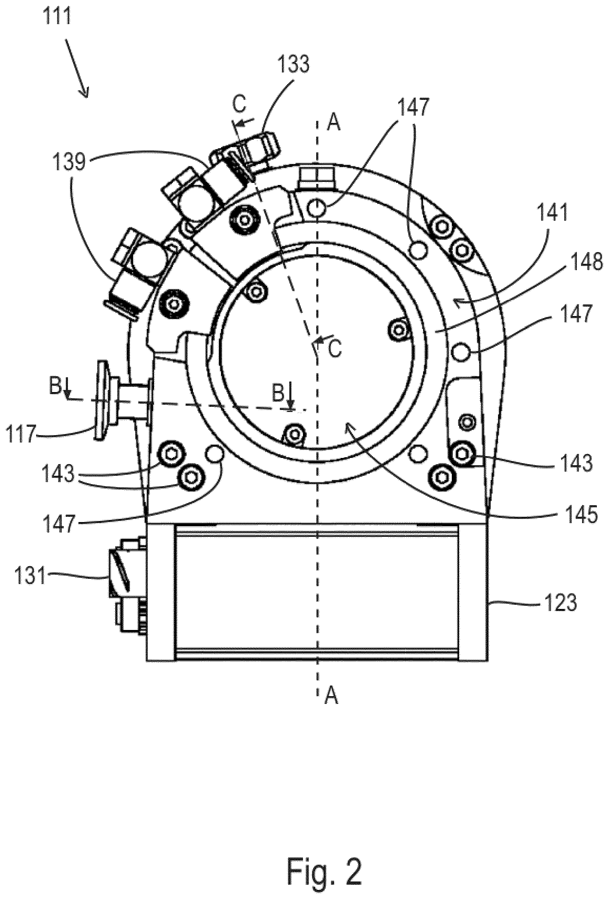

An der Unterseite 141, die in Fig. 2 dargestellt ist, sind noch diverse Schrauben 143 angeordnet, mittels denen hier nicht weiter spezifizierte Bauteile der Vakuumpumpe aneinander befestigt sind. Beispielsweise ist ein Lagerdeckel 145 an der Unterseite 141 befestigt.

An der Unterseite 141 sind außerdem Befestigungsbohrungen 147 angeordnet, über welche die Pumpe 111 beispielsweise an einer Auflagefläche befestigt werden kann. Dies ist bei anderen existierenden Turbomolekularvakuumpumpen (nicht dargestellt), die insbesondere größer sind als die hier dargestellte Pumpe, nicht möglich.

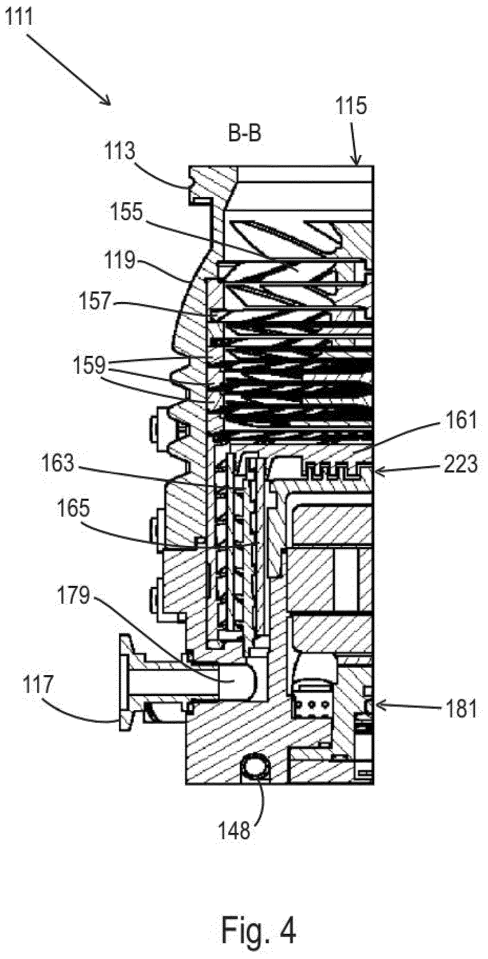

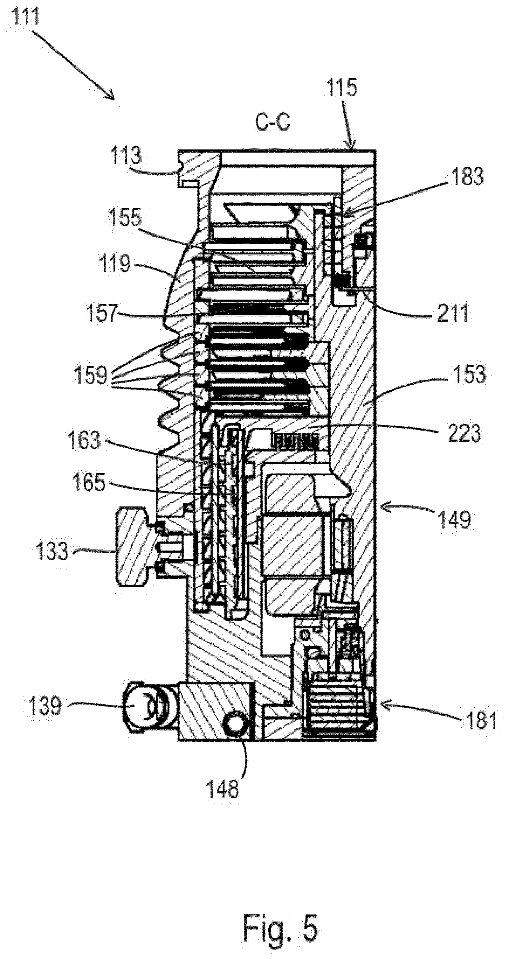

**In** den Figuren 2 bis 5 ist eine Kühlmittelleitung 148 dargestellt, in welcher das über die Kühlmittelanschlüsse 139 ein- und ausgeleitete Kühlmittel zirkulieren kann.

Wie die Schnittdarstellungen der Figuren 3 bis 5 zeigen, umfasst die Vakuumpumpe mehrere Prozessgaspumpstufen zur Förderung des an dem Pumpeneinlass 115 anstehenden Prozessgases zu dem Pumpenauslass 117.

**In** dem Gehäuse 119 ist ein Rotor 149 angeordnet, der eine um eine Rotationsachse 151 drehbare Rotorwelle 153 aufweist.

Die Turbomolekularpumpe 111 umfasst mehrere pumpwirksam miteinander in Serie geschaltete turbomolekulare Pumpstufen mit mehreren an der Rotorwelle 153 befestigten radialen Rotorscheiben 155 und zwischen den Rotorscheiben 155 angeordneten und in dem Gehäuse 119 festgelegten Statorscheiben 157. Dabei bilden eine Rotorscheibe 155 und eine benachbarte Statorscheibe 157 jeweils eine turbomolekulare Pumpstufe. Die Statorscheiben 157 sind durch Abstandsringe 159 in einem gewünschten axialen Abstand zueinander gehalten.

Die Vakuumpumpe umfasst außerdem in radialer Richtung ineinander angeordnete und pumpwirksam miteinander in Serie geschaltete Holweck-Pumpstufen. Es existieren andere Turbomolekularvakuumpumpen (nicht dargestellt), die keine Holweck-Pumpstufen aufweisen.

Der Rotor der Holweck-Pumpstufen umfasst eine an der Rotorwelle 153 angeordnete Rotornabe 161 und zwei an der Rotornabe 161 befestigte und von dieser getragene zylindermantelförmige Holweck-Rotorhülsen 163, 165, die koaxial zur Rotationsachse 151 orientiert und in radialer Richtung ineinander geschachtelt sind. Ferner sind zwei zylindermantelförmige Holweck-Statorhülsen 167, 169 vorgesehen, die ebenfalls koaxial zu der Rotationsachse 151 orientiert und in radialer Richtung gesehen ineinander geschachtelt sind.

Die pumpaktiven Oberflächen der Holweck-Pumpstufen sind durch die Mantelflächen, also durch die radialen Innen- und/oder Außenflächen, der Holweck-Rotorhülsen 163, 165 und der Holweck-Statorhülsen 167, 169 gebildet. Die radiale Innenfläche der äußeren Holweck-Statorhülse 167 liegt der radialen Außenfläche der äußeren Holweck-Rotorhülse 163 unter Ausbildung eines radialen Holweck-Spalts 171 gegenüber und bildet mit dieser die der Turbomolekularpumpen nachfolgende erste Holweck-Pumpstufe. Die radiale Innenfläche der äußeren Holweck-Rotorhülse 163 steht der radialen Außenfläche der inneren Holweck-Statorhülse 169 unter Ausbildung eines radialen Holweck-Spalts 173 gegenüber und bildet mit dieser eine zweite Holweck-Pumpstufe. Die radiale Innenfläche der inneren Holweck-Statorhülse 169 liegt der radialen Außenfläche der inneren Holweck-Rotorhülse 165 unter Ausbildung eines radialen Holweck-Spalts 175 gegenüber und bildet mit dieser die dritte Holweck-Pumpstufe.

Am unteren Ende der Holweck-Rotorhülse 163 kann ein radial verlaufender Kanal vorgesehen sein, über den der radial außenliegende Holweck-Spalt 171 mit dem mittleren Holweck-Spalt 173 verbunden ist. Außerdem kann am oberen Ende der inneren Holweck-Statorhülse 169 ein radial verlaufender Kanal vorgesehen sein, über den der mittlere Holweck-Spalt 173 mit dem radial innenliegenden Holweck-Spalt 175 verbunden ist. Dadurch werden die ineinander geschachtelten Holweck-Pumpstufen in Serie miteinander geschaltet. Am unteren Ende der radial innenliegenden Holweck-Rotorhülse 165 kann ferner ein Verbindungskanal 179 zum Auslass 117 vorgesehen sein.

Die vorstehend genannten pumpaktiven Oberflächen der Holweck-Statorhülsen 167, 169 weisen jeweils mehrere spiralförmig um die Rotationsachse 151 herum in axialer Richtung verlaufende Holweck-Nuten auf, während die gegenüberliegenden Mantelflächen der Holweck-Rotorhülsen 163, 165 glatt ausgebildet sind und das Gas zum Betrieb der Vakuumpumpe 111 in den Holweck-Nuten vorantreiben.

Zur drehbaren Lagerung der Rotorwelle 153 sind ein Wälzlager 181 im Bereich des Pumpenauslasses 117 und ein Permanentmagnetlager 183 im Bereich des Pumpeneinlasses 115 vorgesehen.

Im Bereich des Wälzlagers 181 ist an der Rotorwelle 153 eine konische Spritzmutter 185 mit einem zu dem Wälzlager 181 hin zunehmenden Außendurchmesser vorgesehen. Die Spritzmutter 185 steht mit mindestens einem Abstreifer eines Betriebsmittelspeichers in gleitendem Kontakt. Bei anderen existierenden Turbomolekularvakuumpumpen (nicht dargestellt) kann anstelle einer Spritzmutter eine Spritzschraube vorgesehen sein. Da somit unterschiedliche Ausführungen möglich sind, wird in diesem Zusammenhang auch der Begriff "Spritzspitze" verwendet.

Der Betriebsmittelspeicher umfasst mehrere aufeinander gestapelte saugfähige Scheiben 187, die mit einem Betriebsmittel für das Wälzlager 181, z.B. mit einem Schmiermittel, getränkt sind.

Im Betrieb der Vakuumpumpe 111 wird das Betriebsmittel durch kapillare Wirkung von dem Betriebsmittelspeicher über den Abstreifer auf die rotierende Spritzmutter 185 übertragen und in Folge der Zentrifugalkraft entlang der Spritzmutter 185 in Richtung des größer werdenden Außendurchmessers der Spritzmutter 185 zu dem Wälzlager 181 hin gefördert, wo es z.B. eine schmierende Funktion erfüllt. Das Wälzlager 181 und der Betriebsmittelspeicher sind durch einen wannenförmigen Einsatz 189 und den Lagerdeckel 145 in der Vakuumpumpe eingefasst.

Das Permanentmagnetlager 183 umfasst eine rotorseitige Lagerhälfte 191 und eine statorseitige Lagerhälfte 193, welche jeweils einen Ringstapel aus mehreren in axialer Richtung aufeinander gestapelten permanentmagnetischen Ringen 195, 197 umfassen. Die Ringmagnete 195, 197 liegen einander unter Ausbildung eines radialen Lagerspalts 199 gegenüber, wobei die rotorseitigen Ringmagnete 195 radial außen und die statorseitigen Ringmagnete 197 radial innen angeordnet sind.

Das in dem Lagerspalt 199 vorhandene magnetische Feld ruft magnetische Absto-ßungskräfte zwischen den Ringmagneten 195, 197 hervor, welche eine radiale Lagerung der Rotorwelle 153 bewirken. Die rotorseitigen Ringmagnete 195 sind von einem Trägerabschnitt 201 der Rotorwelle 153 getragen, welcher die Ringmagnete 195 radial außenseitig umgibt. Die statorseitigen Ringmagnete 197 sind von einem statorseitigen Trägerabschnitt 203 getragen, welcher sich durch die Ringmagnete 197 hindurch erstreckt und an radialen Streben 205 des Gehäuses 119 aufgehängt ist. Parallel zu der Rotationsachse 151 sind die rotorseitigen Ringmagnete 195 durch ein mit dem Trägerabschnitt 201 gekoppeltes Deckelelement 207 festgelegt. Die statorseitigen Ringmagnete 197 sind parallel zu der Rotationsachse 151 in der einen Richtung durch einen mit dem Trägerabschnitt 203 verbundenen Befestigungsring 209 sowie einen mit dem Trägerabschnitt 203 verbundenen Befestigungsring 211 festgelegt. Zwischen dem Befestigungsring 211 und den Ringmagneten 197 kann außerdem eine Tellerfeder 213 vorgesehen sein.

Innerhalb des Magnetlagers ist ein Not- bzw. Fanglager 215 vorgesehen, welches im normalen Betrieb der Vakuumpumpe 111 ohne Berührung leer läuft und erst bei einer übermäßigen radialen Auslenkung des Rotors 149 relativ zu dem Stator in Eingriff gelangt, um einen radialen Anschlag für den Rotor 149 zu bilden, damit eine Kollision der rotorseitigen Strukturen mit den statorseitigen Strukturen verhindert wird. Das Fanglager 215 ist als ungeschmiertes Wälzlager ausgebildet und bildet mit dem Rotor 149 und/oder dem Stator einen radialen Spalt, welcher bewirkt, dass das Fanglager 215 im normalen Pumpbetrieb außer Eingriff ist. Die radiale Auslenkung, bei der das Fanglager 215 in Eingriff gelangt, ist groß genug bemessen, sodass das Fanglager 215 im normalen Betrieb der Vakuumpumpe nicht in Eingriff gelangt, und gleichzeitig klein genug, sodass eine Kollision der rotorseitigen Strukturen mit den statorseitigen Strukturen unter allen Umständen verhindert wird.

Die Vakuumpumpe 111 umfasst den Elektromotor 125 zum drehenden Antreiben des Rotors 149. Der Anker des Elektromotors 125 ist durch den Rotor 149 gebildet, dessen Rotorwelle 153 sich durch den Motorstator 217 hindurch erstreckt. Auf den sich durch den Motorstator 217 hindurch erstreckenden Abschnitt der Rotorwelle 153 kann radial außenseitig oder eingebettet eine Permanentmagnetanordnung angeordnet sein. Zwischen dem Motorstator 217 und dem sich durch den Motorstator 217 hindurch erstreckenden Abschnitt des Rotors 149 ist ein Zwischenraum 219 angeordnet, welcher einen radialen Motorspalt umfasst, über den sich der Motorstator 217 und die Permanentmagnetanordnung zur Übertragung des Antriebsmoments magnetisch beeinflussen können.

Der Motorstator 217 ist in dem Gehäuse innerhalb des für den Elektromotor 125 vorgesehenen Motorraums 137 festgelegt. Über den Sperrgasanschluss 135 kann ein Sperrgas, das auch als Spülgas bezeichnet wird, und bei dem es sich beispielsweise um Luft oder um Stickstoff handeln kann, in den Motorraum 137 gelangen. Über das Sperrgas kann der Elektromotor 125 vor Prozessgas, z.B. vor korrosiv wirkenden Anteilen des Prozessgases, geschützt werden. Der Motorraum 137 kann auch über den Pumpenauslass 117 evakuiert werden, d.h. im Motorraum 137 herrscht zumindest annäherungsweise der von der am Pumpenauslass 117 angeschlossenen Vorvakuumpumpe bewirkte Vakuumdruck.

Zwischen der Rotornabe 161 und einer den Motorraum 137 begrenzenden Wandung 221 kann außerdem eine sog. und an sich bekannte Labyrinthdichtung 223 vorgesehen sein, insbesondere um eine bessere Abdichtung des Motorraums 217 gegenüber den radial außerhalb liegenden Holweck-Pumpstufen zu erreichen.

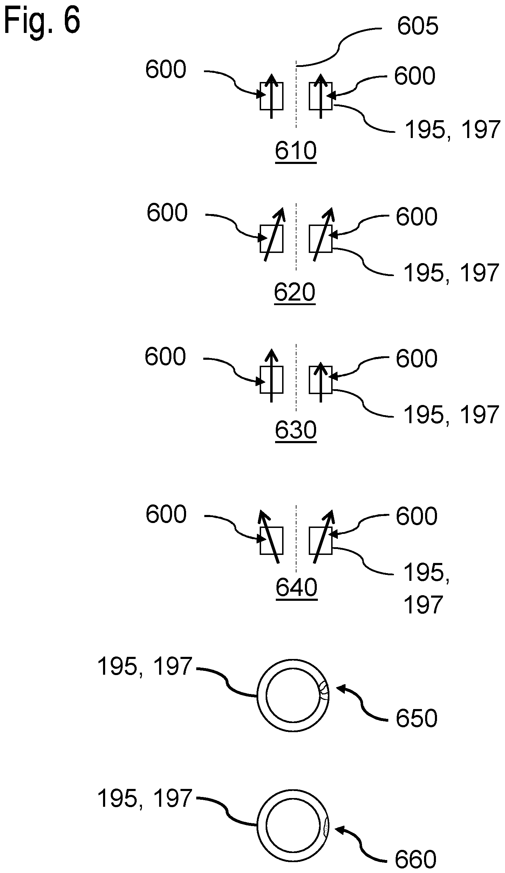

In Fig. 6 sind unterschiedliche Magnetisierungseigenschaften der Ringmagnete 195, 197 des Permanentmagnetlagers 183 schematisch dargestellt. Die oberen vier Darstellungen zeigen eine Querschnittsansicht eines der Ringmagnete 195, 197 zusammen mit einem lokalen Magnetisierungsvektor 600 und einer Symmetrieachse 605 des Ringmagneten 195, 197. Der Begriff "lokaler Magnetisierungsvektor 600" bedeutet in diesem Zusammenhang, dass die Magnetisierung nicht global bzw. summiert für den gesamten Ringmagnet 195, 197, sondern lokal entlang dessen Umfang betrachtet wird, beispielsweise unter Verwendung von Zylinderkoordinaten. Die unteren beiden Darstellungen zeigen jeweils eine schematische Draufsicht auf einen der Ringmagnete 195, 197.

In der oberen Darstellung ist eine ideale Magnetisierung 610 des Ringmagneten 195, 197 gezeigt, bei welcher die Magnetisierung bzw. der lokale Magnetisierungsvektor 600 über den Umfang des Ringmagneten 195, 197 einen im Wesentlichen konstanten Betrag aufweist und stets parallel zur Symmetrieachse 605 des Ringmagneten 195, 197 ausgerichtet ist. In der zweiten Darstellung darunter ist hingegen ein Winkelfehler 620 dargestellt, bei welchem der Betrag des Magnetisierungsvektors 600 zwar über den Umfang des Ringmagneten 195, 197 im Wesentlichen konstant ist, aber bezüglich der Symmetrieachse 605 geneigt ist. Diese Neigung bzw. Richtungsabweichung des lokalen Magnetisierungsvektors 600 einzelner Ringmagnetsegmente von der Symmetrieachse 605 ist entlang des Umfangs des Ringmagneten 195, 197 nicht konstant, sondern veränderlich.

Die dritte Darstellung darunter zeigt eine Inhomogenität 630, bei welcher der Magnetisierungsvektor 600 über den Umfang des Ringmagneten 195, 197 zwar parallel zur Symmetrieachse 605 ausgerichtet ist, während sich jedoch der Betrag des Magnetisierungsvektors 600 über den Umfang des Ringmagneten 195, 197 ändert.

Die Darstellung darunter zeigt den so genannten Nord-Süd-Effekt 640, bei welchem der lokale Magnetisierungsvektor 600 der einzelnen Ringmagnetsegmente über den Umfang des Ringmagneten 195, 197 einen konstanten Betrag aufweist und bezüglich der Symmetrieachse 605 entlang des Umfangs des Ringmagneten 195, 197 in der lokalen Betrachtung in Zylinderkoordinaten in die gleiche Richtung geneigt und damit konstant ist. Dadurch entsteht gegenüber der Symmetrieachse 605 über den Umfang des Ringmagneten 195, 197 hinweg global gesehen eine kegelförmige Ausrichtung der jeweiligen Magnetisierungsvektoren 600.

Die vorletzte Darstellung in Fig. 6 zeigt eine Draufsicht des Ringmagneten 195, 197, der Mikrorisse 650 aufweist, während die unterste Darstellung von Fig. 6 eine Draufsicht des Ringmagneten 195, 197 zeigt, der eine mechanische Beschädigung in der Form eines so genannten "Abplatzers" 660 aufweist. Die Mikrorisse 650 und der Abplatzer 660 können zu einer Inhomogenität der Magnetisierung bzw. des Magnetisierungsvektors 600 entlang des Umfangs des Ringmagneten 195, 197 und/oder zu einer fehlerhaften Ausrichtung des Magnetisierungsvektors 600 über den Umfang des Ringmagneten 195, 197 bezüglich der Symmetrieachse 605 führen.

Die vorstehend beschriebenen individuellen Magnetisierungseigenschaften jeweiliger Ringmagnete 195, 197, d. h. die jeweilige Abweichung von der idealen Magnetisierung 610, bewirken jeweils zusätzliche Kräfte, insbesondere radiale Kräfte, innerhalb des Permanentmagnetlagers 183. Im Falle der radialen Kräfte entstehen bei einer Drehung des Rotors 149 (vgl. Fig. 3-5) harmonisch umlaufende Radialkräfte, die auch als Magnetlagerfehler bezeichnet werden. Der Magnetlagerfehler ist somit ebenso wie jede der Radialkräfte ein Vektor mit Betrag und Winkelrichtung bzw. Winkellage. Ein solcher Magnetlagerfehler beeinflusst bzw. beeinträchtigt die Laufeigenschaften des Rotors 149 der Turbomolekularpumpe 111 vor allem bei geringen Drehzahlen in einer ähnlichen Weise wie eine Unwucht des Rotors 149. Durch den Magnetlagerfehler können folglich ebenso wie bei einer Unwucht Vibrationen und Geräusche innerhalb der Turbomolekularpumpe 111 auftreten. Die erfindungsgemäße Vorrichtung und das erfindungsgemäße Verfahren sind dafür vorgesehen, den Magnetlagerfehler und/oder ein magnetisches Streufeld, das ebenfalls durch die in Fig. 6 gezeigten individuellen Magnetisierungseigenschaften der Ringmagnete 195, 197 hervorgerufen werden kann, für das Permanentmagnetlager 183 zu ermitteln. Anhand des Magnetlagerfehlers und/oder des magnetischen Streufelds wird das Permanentmagnetlager 183 bewertet, um es anschließend optimieren zu können.

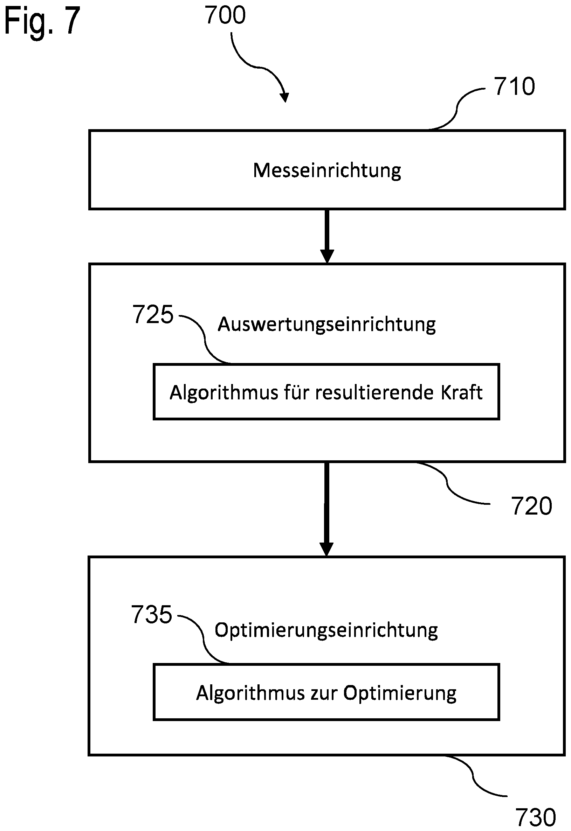

Fig. 7 zeigt ein Blockdiagramm einer Vorrichtung 700 zum Bewerten des Permanentmagnetlagers 183 der Turbomolekularpumpe 111, das in der rotorseitigen Lagerhälfte 191 die Ringmagnete 195 und in der statorseitigen Lagerhälfte 193 die Ringmagnete 197 aufweist (vgl. Fig. 3). Die Vorrichtung 700 umfasst eine Messeinrichtung 710, eine Auswertungseinrichtung 720 und eine Optimierungseinrichtung 730.

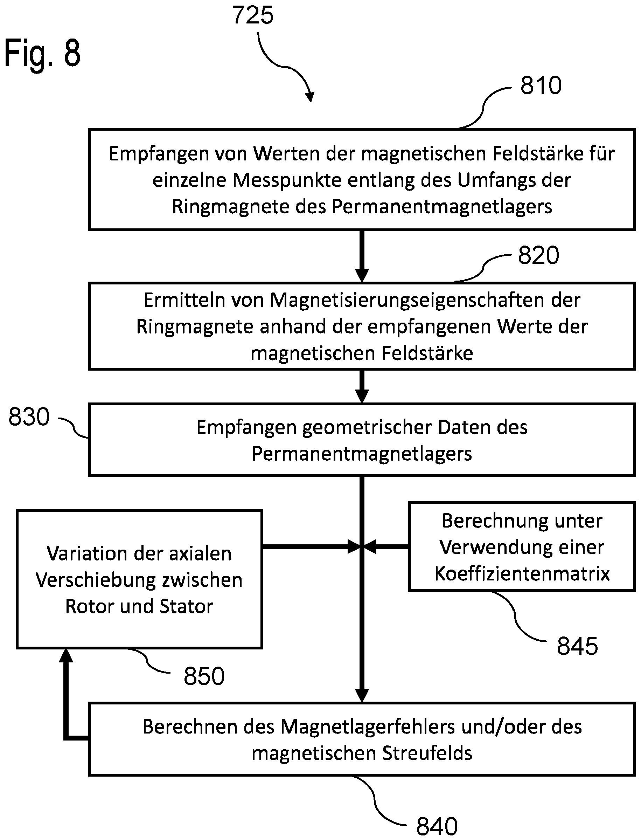

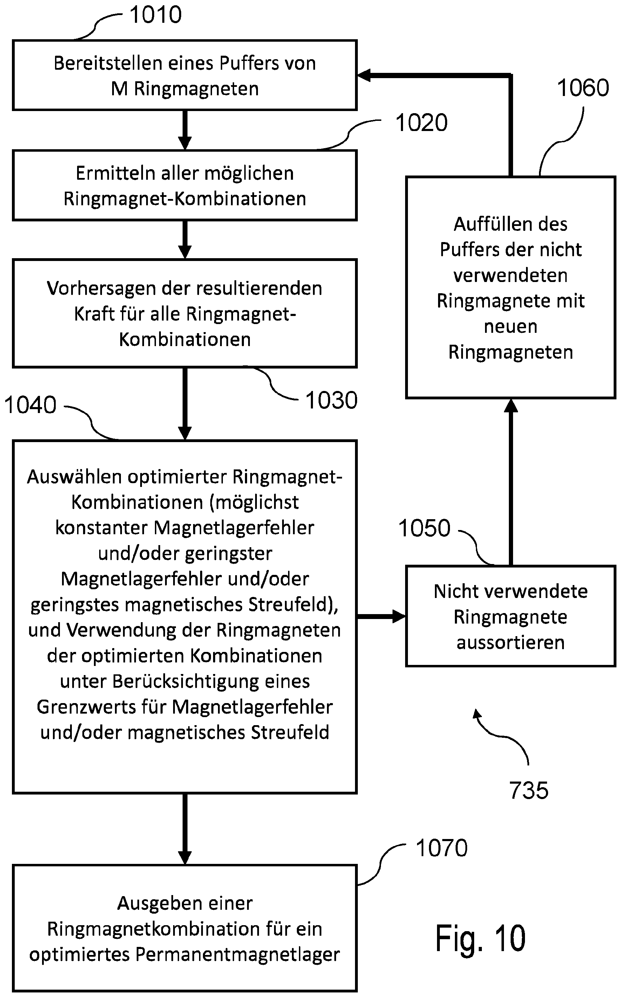

Die Messeinrichtung 710 ist dafür vorgesehen, Messwerte der magnetischen Feldstärke an mehreren Positionen entlang des Umfangs der jeweiligen Ringmagnete 195, 197 zu erfassen. Die Auswertungseinrichtung 720 ist mit der Messeinrichtung 710 kommunikativ verbunden und ausgebildet, um einen Algorithmus 725 auszuführen, der im Zusammenhang mit Fig. 8 näher erläutert ist und zum Ermitteln bzw. Voraussagen zumindest einer resultierenden Kraft vorgesehen ist, welche die Ringmagnete 195, 197 auf den Rotor 149 ausüben. Die Auswertungseinrichtung 720 ist ferner ausgebildet, anhand der ermittelten resultierenden Kraft eine Bewertung des Permanentmagnetlagers 183 zu ermitteln und diese an die Optimierungseinrichtung 730 auszugeben. Die Auswertungseinrichtung 720 ermittelt ferner den vorstehend beschriebenen Magnetlagerfehler anhand der zumindest einen resultierenden Kraft und/oder das magnetische Streufeld des Permanentmagnetlagers 183, um diese ebenfalls an die Optimierungseinrichtung 730 auszugeben. Basierend auf den Informationen, welche die Auswertungseinrichtung 720 bereitstellt, führt die Optimierungseinrichtung einen Algorithmus 735 bzw. Verfahrensschritte zur Optimierung des Permanentmagnetlagers 183 aus, wie diese im Zusammenhang mit Fig. 10 näher erläutert sind. Die Optimierung erfolgt vor der Montage des Permanentmagnetlagers 183 innerhalb der Turbomolekularpumpe 111 anhand einer Vielzahl von Ringmagneten 195, 197, von denen eine optimale Kombination ausgewählt wird, indem für eine Vielzahl von Kombinationen der Ringmagnete 195, 197 jeweils die zumindest eine resultierende Kraft vorausgesagt wird, um die jeweilige Kombination zu bewerten.

Fig. 8 zeigt ein Blockdiagramm des Algorithmus 725 für die resultierende Kraft, der von der Auswertungseinrichtung 720 (vgl. Fig. 7) ausgeführt wird. Bei 810 werden Messwerte der magnetischen Feldstärke für einzelne Messpunkte bzw. an mehreren vorbestimmten Positionen entlang des Umfangs der Ringmagnete 195, 197 des Permanentmagnetlagers 183 empfangen, wobei diese Messwerte bereits zuvor, d.h. vor der Montage des Permanentmagnetlagers 183, von der Messeinrichtung 710 (vgl. Fig. 7) erfasst werden. Die Ringmagnete 195, 197 werden während dieses Messvorgangs einzeln vermessen. Anschließend werden bei 820 Magnetisierungseigenschaften der Ringmagnete 195, 197 anhand der empfangenen Werte der magnetischen Feldstärke ermittelt. Die Magnetisierungseigenschaften werden durch einen oder mehrere Magnetisierungsvektoren 600 (vgl. Fig. 6) repräsentiert, die entweder für Segmente oder Abschnitte des jeweiligen Ringmagneten 195, 197 oder als resultierender Vektor für den gesamten Ringmagneten 195, 197 ermittelt werden. Die Magnetisierungseigenschaften beinhalten ferner die Abweichungen von der idealen Magnetisierung 610 des jeweiligen Ringmagneten 195, 197, wie diese bei 620 bis 660 in Fig. 6 dargestellt sind.

Bei 830 werden geometrische Daten des Permanentmagnetlagers 183 empfangen. Die Geometriedaten des Permanentmagnetlagers 183 sind vorgegeben und umfassen die Abmessungen der jeweiligen Ringmagneten 195, 197, die Anzahl der Ringmagnete 195, 197 im Permanentmagnetlager 183 und deren jeweilige Abstände zueinander.

Anhand der bei 820 ermittelten Magnetisierungseigenschaften der Ringmagnete 195, 197 und anhand der bei 830 empfangenen geometrischen Daten des Permanentmagnetlagers 183 werden bei 840 der Magnetlagerfehler, d.h. die harmonisch umlaufende Radialkraft, die auf den Rotor 149 wirkt, und/oder das magnetische Streufeld des Permanentmagnetlagers 183 berechnet. Die Berechnung bei 840 erfolgt unter Verwendung einer Koeffizientenmatrix, wie dies durch den Block 845 dargestellt ist. Die Koeffizientenmatrix beschreibt den Einfluss der jeweiligen Magnetisierungseigenschaften der im Permanentmagnetlager vorhandenen Ringmagnete 195, 197 auf die jeweiligen Kräfte, die von dem jeweiligen Ringmagneten 195, 197 ausgeübt werden. Die resultierende Kraft für das Permanentmagnetlager 183 bzw. der entsprechende Magnetlagerfehler werden anschließend durch eine vektorielle Addition der einzelnen Kräfte der jeweiligen Ringmagnete 195, 197 ermittelt.

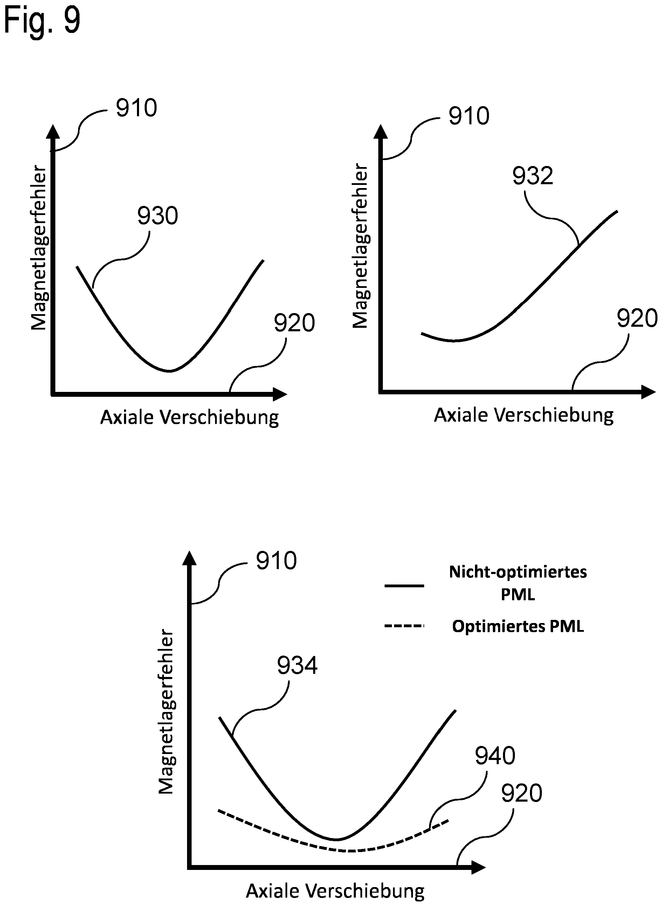

Das Berechnen des Magnetlagerfehlers und/oder des magnetischen Streufelds für das Permanentmagnetlager 183 erfolgt ferner iterativ, wobei für jeden Iterationsschritt bei 850 eine axiale Verschiebung zwischen dem Rotor 149 und dem Stator variiert wird. Der Magnetlagerfehler und/oder das magnetische Streufeld werden somit in Abhängigkeit dieser axialen Verschiebung zwischen Rotor 149 und Stator berechnet. Dadurch ergibt sich ein Verlauf des Magnetlagerfehlers für das Permanentmagnetlager 183 in Abhängigkeit von der axialen Verschiebung, wie dies in Fig. 9 dargestellt ist.

Es hat sich gezeigt, dass für optimale Laufeigenschaften des Permanentmagnetlagers 183 bzw. des Rotors 149, der durch dieses gelagert wird, der Magnetlagerfehler eine möglichst geringe Abhängigkeit von der axialen Verschiebung des Rotors 149 bezüglich des Stators bzw. einen flachen Verlauf bei einer solchen Verschiebung aufweisen sollte.

In Fig. 9 sind drei verschiedene Diagramme dargestellt, bei denen jeweils der Magnetlagerfehler 910 an der y-Achse über der axialen Verschiebung 920 an der x-Achse aufgetragen ist. Die Kurven 930, 932 und 934 zeigen ein jeweiliges Beispiel des Magnetlagerfehlers 910 für ein nicht-optimiertes Permanentmagnetlager.

Wie man erkennen kann, ändert sich der Betrag des Magnetlagerfehlers 910 sehr stark in Abhängigkeit von der axialen Verschiebung, und zwar derart, dass im Vergleich zu einem minimalen Wert ein Vielfaches für den Betrag des Magnetlagerfehlers erreicht wird, sobald die axiale Verschiebung ausreichend zunimmt oder abnimmt. Außerdem kann eine Veränderung der Phasenrichtung bzw. Winkelrichtung des Magnetlagerfehlers 910 in Abhängigkeit von der axialen Verschiebung auftreten, die jedoch hier nicht dargestellt ist.

Zum Vergleich ist im unteren Diagramm von Fig. 9 der Verlauf des Betrags des Magnetlagerfehlers 910 in Abhängigkeit von der axialen Verschiebung für ein Permanentmagnetlager 183 dargestellt, das unter Verwendung des in Fig. 10 dargestellten Algorithmus bzw. Verfahrens optimiert ist, der nachstehend näher erläutert wird. Wie man erkennen kann, bewirkt die Optimierung des Permanentmagnetlagers 183 im Vergleich zu der Kurve 934 für das nicht-optimierte Permanentmagnetlager einen erheblich flacheren Verlauf 940 in Abhängigkeit von der axialen Verschiebung 920, wobei der Betrag des Magnetlagerfehlers 910 bei geringen und relativ großen Werten der axialen Verschiebung 920 im Vergleich zu dem Verlauf 934 für das nicht-optimierte Permanentmagnetlager um etwa eine Größenordnung geringer ist. Durch den flachen Verlauf 940 für den Betrag des Magnetlagerfehlers 910 werden folglich die Laufeigenschaften des Permanentmagnetlagers 183 bzw. des Rotors 149 deutlich verbessert.

In Fig. 10 sind der Algorithmus 735 zur Optimierung des Permanentmagnetlagers 183 bzw. entsprechende Verfahrensschritte schematisch dargestellt. Der Algorithmus 735 zur Optimierung des Permanentmagnetlagers 183 wird von der Optimierungseinrichtung 730 ausgeführt (vgl. Fig. 7).

Bei 1010 wird eine vorbestimmte Vielzahl M von Ringmagneten 195, 197 als ein Puffer bereitgestellt. Die vorbestimmte Vielzahl M der Ringmagneten 195, 197 beträgt beispielsweise 50 und ist damit größer als eine Anzahl N von Ringmagneten 195, 197, die zum Aufbau des Permanentmagnetlagers 183 erforderlich ist. Im Beispiel von Fig. 3 sind jeweils fünf Ringmagnete 195 und fünf Ringmagnete 197 in der rotorseitigen bzw. statorseitigen Lagerhälfte 191, 193 vorhanden. Innerhalb des Algorithmus 735 enthält der bei 1010 bereitgestellte Puffer von Ringmagneten 195, 197 nicht die Ringmagnete an sich, sondern deren Messwerte der magnetischen Feldstärke, die für jeden Ringmagnet 195, 197 des Puffers mittels der Messeinrichtung 710 (vgl. Fig. 7) ermittelt werden.

Bei 1020 werden alle Kombinationen der in dem bei 1010 bereitgestellten Puffer vorhandenen M Ringmagneten 195, 197 ermittelt, mit denen es möglich ist, das Permanentmagnetlager 183 zu bilden bzw. zusammenzusetzen. Für jede dieser Kombinationen von Ringmagneten 195, 197 wird bei 1030 die zumindest eine resultierende Kraft vorhergesagt bzw. berechnet, wie dies vorstehend im Zusammenhang mit Fig. 8 beschrieben ist. Mit anderen Worten wird der Algorithmus 725, der in Fig. 8 dargestellt ist, bei 1030 iterativ für jede der bei 1020 ermittelten möglichen Kombinationen von Ringmagneten 195, 197 ausgeführt. Dies umfasst, dass auch der Verlauf bzw. die Abhängigkeit der resultierenden Kraft bzw. des Magnetlagerfehlers und/oder des Streufelds von der Verschiebung zwischen dem Rotor 149 und dem Stator der Turbomolekularpumpe 111 ermittelt wird.

Anhand der Resultate, die bei 1030 ermittelt werden, werden bei 1040 optimierte Kombinationen der Ringmagnete 195, 197 ausgewählt, die einer vorbestimmten Optimierungsbedingung am nächsten kommen. Die Optimierungsbedingung umfasst, dass ein möglichst konstanter Magnetlagerfehler bezogen auf die Verschiebung des Rotors 149 und des Stators und/oder ein möglichst geringer Magnetlagerfehler und/oder ein möglichst geringes magnetisches Streufeld für die jeweilige Kombination von Ringmagneten 195, 197 vorhanden ist. Ferner wird bei 1040 von den ausgewählten optimierten Kombinationen von Ringmagneten 195, 197 die beste Kombination unter Berücksichtigung eines Grenzwerts für den Magnetlagerfehler und/oder für das magnetische Streufeld ermittelt, um diese Kombination zu verwenden.

Die nicht verwendeten Ringmagnete 195, 197 des Puffers mit M Ringmagneten werden bei 1050 aussortiert, um den Puffer der nicht verwendeten Ringmagnete 195, 197 bei 1060 anschließend wieder mit neuen Ringmagneten 195, 197 aufzufüllen. Dies bedeutet wiederum, dass die entsprechenden Messwerte der magnetischen Feldstärke für weitere Ringmagneten 195, 197 zusätzlich bereitgestellt werden, wobei diese Messwerte der magnetischen Feldstärke mittels der Messeinrichtung 710 (vgl. Fig. 7) erfasst werden.

Schließlich wird die bei 1040 ermittelte Kombination von Ringmagneten 195, 197 bei 1070 ausgegeben, um mittels dieser Kombination von Ringmagneten 195, 197 das optimierte Permanentmagnetlager 183 zu bilden.

### Bezugszeichenliste

- 111: Turbomolekularpumpe
- 113: Einlassflansch
- 115: Pumpeneinlass
- 117: Pumpenauslass
- 119: Gehäuse
- 121: Unterteil
- 123: Elektronikgehäuse
- 125: Elektromotor
- 127: Zubehöranschluss
- 129: Datenschnittstelle
- 131: Stromversorgungsanschluss
- 133: Fluteinlass
- 135: Sperrgasanschluss
- 137: Motorraum
- 139: Kühlmittelanschluss
- 141: Unterseite
- 143: Schraube
- 145: Lagerdeckel
- 147: Befestigungsbohrung
- 148: Kühlmittelleitung
- 149: Rotor
- 151: Rotationsachse
- 153: Rotorwelle
- 155: Rotorscheibe
- 157: Statorscheibe
- 159: Abstandsring
- 161: Rotornabe
- 163: Holweck-Rotorhülse
- 165: Holweck-Rotorhülse
- 167: Holweck-Statorhülse
- 169: Holweck-Statorhülse
- 171: Holweck-Spalt
- 173: Holweck-Spalt
- 175: Holweck-Spalt
- 179: Verbindungskanal
- 181: Wälzlager
- 183: Permanentmagnetlager
- 185: Spritzmutter
- 187: Scheibe
- 189: Einsatz
- 191: rotorseitige Lagerhälfte
- 193: statorseitige Lagerhälfte
- 195: Ringmagnet
- 197: Ringmagnet
- 199: Lagerspalt
- 201: Trägerabschnitt
- 203: Trägerabschnitt
- 205: radiale Strebe
- 207: Deckelelement
- 209: Stützring
- 211: Befestigungsring
- 213: Tellerfeder
- 215: Not- bzw. Fanglager
- 217: Motorstator
- 219: Zwischenraum
- 221: Wandung
- 223: Labyrinthdichtung
- 600: Magnetisierungsvektor
- 605: Symmetrieachse
- 610: ideale Magnetisierung
- 620: Winkelfehler
- 630: Inhomogenität
- 640: Nord-Süd-Effekt
- 650: Mikrorisse
- 660: Abplatzer
- 700: Vorrichtung zum Bewerten eines Magnetlagers
- 710: Messeinrichtung
- 720: Auswertungseinrichtung
- 725: Algorithmus für resultierende Kraft
- 730: Optimierungseinrichtung
- 735: Algorithmus zur Optimierung des Magnetlagers
- 810 bis 850: Schritte des Algorithmus für resultierende Kraft
- 910: Magnetlagerfehler
- 920: axiale Verschiebung
- 930, 932, 934: Verlauf des Magnetlagerfehlers für ein nicht-optimiertes Permanentmagnetlager
- 940: Verlauf des Magnetlagerfehlers für ein optimiertes Permanentmagnetlager
- 1010 bis 1070: Schritte des Algorithmus zur Optimierung des Magnetlagers

## Patentansprüche

1. Vorrichtung (700) zum Bewerten eines Magnetlagers (183) einer Vakuumpumpe, insbesondere einer Turbomolekularpumpe (111), welches mehrere Magnetelemente (195, 197) aufweist, um einen Rotor (149) an einem Stator drehbar zu lagern,
wobei die Vorrichtung (700) umfasst:
eine Messeinrichtung (710), die ausgebildet ist, um Messwerte der magnetischen Feldstärke an mehreren vorbestimmten Positionen eines jeweiligen der mehreren Magnetelemente (195, 197) zu erfassen, und
eine Auswertungseinrichtung (720), die mit der Messeinrichtung (710) kommunikativ verbunden ist und ausgebildet ist, um:
für jedes der Magnetelemente (195, 197) die von der Messeinrichtung (710) erfassten Messwerte der magnetischen Feldstärke zu empfangen,
Magnetisierungseigenschaften für jedes der Magnetelemente (195, 197) anhand der Messwerte der magnetischen Feldstärke zu ermitteln,
vorgegebene Geometriedaten des Magnetlagers (183) zu empfangen,
anhand der Magnetisierungseigenschaften jedes der Magnetelemente (195, 197) und anhand der vorgegebenen Geometriedaten des Magnetlagers (183) zumindest eine resultierende Kraft zu ermitteln, welche die Magnetelemente (195, 197) auf den Rotor (149) ausüben und
anhand der resultierenden Kraft eine Bewertung des Magnetlagers (183) zu ermitteln und auszugeben,
**dadurch gekennzeichnet, dass**
die Auswertungseinrichtung (720) ferner ausgebildet ist, um die zumindest eine resultierende Kraft in Abhängigkeit von einer axialen Verschiebung des Rotors (149) bezüglich des Stators zu ermitteln und das Magnetlager (183) anhand der Abhängigkeit der resultierenden Kraft von der axialen Verschiebung des Rotors (149) bezüglich des Stators zu bewerten.

2. Vorrichtung (700) nach Anspruch 1, wobei
die Auswertungseinrichtung (710) ferner ausgebildet ist, um:
eine Koeffizientenmatrix zu bilden, welche die Abhängigkeit einzelner Kräfte, die die jeweiligen Magnetelemente (195, 197) auf den Rotor (149) ausüben, von den jeweiligen Magnetisierungseigenschaften der einzelnen Magnetelemente (195, 197) beschreibt, und
die resultierende Kraft durch eine vektorielle Addition der einzelnen Kräfte der jeweiligen Magnetelemente (195, 197) zu ermitteln.

3. Vorrichtung (700) nach Anspruch 1 oder 2, wobei
die Auswertungseinrichtung (710) ferner ausgebildet ist, um einen Magnetlagerfehler anhand der zumindest einen resultierenden Kraft und/oder ein magnetisches Streufeld des Magnetlagers (183) anhand der Magnetisierungseigenschaften jedes der Magnetelemente (195, 197) und anhand der vorgegebenen Geometriedaten des Magnetlagers zu ermitteln und auszugeben.

4. Vorrichtung (700) nach Anspruch 3, wobei
die Vorrichtung (700) eine Optimierungseinrichtung (730) umfasst, die ausgebildet ist, um die vorgegebenen Geometriedaten des Magnetlagers (183) und/oder Parameter der Magnetelemente (195, 197) derart zu variieren, dass der Magnetlagerfehler und/oder das magnetische Streufeld des Magnetlagers (183) eine vorbestimmte Optimierungsbedingung erfüllen.

5. Vorrichtung (700) nach einem der Ansprüche 1 bis 4, wobei
das Magnetlager als ein Permanentmagnetlager (183) ausgebildet ist, bei welchem die Magnetelemente eine vorgegebene Anzahl von Ringmagneten (195, 197) umfassen, und
die Messeinrichtung (710) ausgebildet ist, um die magnetische Feldstärke entlang eines Umfangs jedes Einzelnen der Ringmagnete (195, 197) des Magnetlagers (183) zu ermitteln.

6. Verfahren zum Bewerten eines Magnetlagers (183) einer Vakuumpumpe, insbesondere einer Turbomolekularpumpe (111), welches mehrere Magnetelemente (195, 197) aufweist, um einen Rotor (149) an einem Stator drehbar zu lagern,
wobei das Verfahren umfasst, dass:
a) Messwerte der magnetischen Feldstärke an mehreren vorbestimmten Positionen eines jeweiligen der mehreren Magnetelemente (195, 197) erfasst werden,
b) Magnetisierungseigenschaften für jedes der Magnetelemente (195, 197) anhand der Messwerte der magnetischen Feldstärke ermittelt werden,
c) vorgegebene Geometriedaten des Magnetlagers (183) empfangen werden,
d) anhand der Magnetisierungseigenschaften jedes der Magnetelemente (195, 197) und anhand der vorgegebenen Geometriedaten des Magnetlagers (183) zumindest eine resultierende Kraft ermittelt wird, welche die Magnetelemente (195, 197) auf den Rotor (149) ausüben, und
e) eine Bewertung des Magnetlagers (183) anhand der resultierenden Kraft ermittelt und ausgegeben wird,
**dadurch gekennzeichnet, dass**
die zumindest eine resultierende Kraft in Abhängigkeit von einer axialen Verschiebung des Rotors (149) bezüglich des Stators ermittelt wird und das Magnetlager (183) anhand der Abhängigkeit der resultierenden Kraft von der axialen Verschiebung des Rotors (149) bezüglich des Stators bewertet wird.

7. Verfahren nach Anspruch 6, wobei
eine Koeffizientenmatrix gebildet wird, welche die Abhängigkeit einzelner Kräfte, die die jeweiligen Magnetelemente (195, 197) auf den Rotor (149) ausüben, von den jeweiligen Magnetisierungseigenschaften der einzelnen Magnetelemente (195, 197) beschreibt, und
die resultierende Kraft durch eine vektorielle Addition der einzelnen Kräfte der jeweiligen Magnetelemente (195, 197) ermittelt wird.

8. Verfahren nach Anspruch 6 oder 7, wobei
ferner ein Magnetlagerfehler anhand der zumindest einen resultierenden Kraft und/oder ein magnetisches Streufeld des Magnetlagers (183) anhand der Magnetisierungseigenschaften jedes der Magnetelemente (195, 197) und anhand der vorgegebenen Geometriedaten des Magnetlagers (183) ermittelt wird.

9. Verfahren nach Anspruch 8, wobei
die vorgegebenen Geometriedaten des Magnetlagers (183) und/oder Parameter der Magnetelemente derart variiert werden, dass der Magnetlagerfehler und/oder das magnetische Streufeld des Magnetlagers (183) eine vorbestimmte Optimierungsbedingung erfüllen.

10. Verfahren nach Anspruch 9, wobei
wobei das Magnetlager als ein Permanentmagnetlager (183) ausgebildet ist und die Magnetelemente eine vorgegebene Anzahl N von Ringmagneten (195, 197) umfassen,
wobei das Variieren der Parameter der Magnetelemente (195, 197) umfasst, dass:
eine vorbestimmte Vielzahl M von Ringmagneten (195, 197) bereitgestellt wird, die größer als die vorgegebene Anzahl N der Ringmagnete (195, 197) ist,
eine Kombination von N Ringmagneten (195, 197) aus der vorbestimmten Vielzahl M der Ringmagnete (195, 197) ausgewählt wird, für welche der Magnetlagerfehler und/oder das magnetische Streufeld des Magnetlagers die vorbestimmte Optimierungsbedingung erfüllen.

11. Verfahren nach Anspruch 10, wobei
für die vorbestimmte Vielzahl M von Ringmagneten (195, 197) jede mögliche Kombination von N Ringmagneten (195, 197) zum Bilden des Magnetlagers ermittelt wird,
für jede ermittelte Kombination von N Ringmagneten (195, 197) die Schritte a) bis e) ausgeführt werden, um für die jeweilige Kombination den jeweiligen Magnetlagerfehler anhand der jeweiligen zumindest einen resultierenden Kraft und/oder ein jeweiliges magnetisches Streufeld des Magnetlagers (183) anhand der Magnetisierungseigenschaften der N Ringmagnete (195, 197) der jeweiligen Kombination und anhand der vorgegebenen Geometriedaten des Magnetlagers (183) zu ermitteln, und
diejenige Kombination von N Ringmagneten (195, 197) ausgewählt wird, für die der jeweilige Magnetlagerfehler und/oder das jeweilige magnetische Streufeld die vorbestimmte Optimierungsbedingung am besten erfüllen.

12. Verfahren nach einem der Ansprüche 9 bis 11,
wobei die vorbestimmte Optimierungsbedingung umfasst, dass der Magnetlagerfehler und/oder das magnetische Streufeld entlang einer axialen Richtung des Magnetlagers (183) im Wesentlichen konstant sind, und/oder
wobei die vorbestimmte Optimierungsbedingung umfasst, dass der jeweilige Betrag des Magnetlagerfehlers und/oder des magnetischen Streufelds kleiner als ein vorbestimmter Schwellenwert ist.

13. Vakuumpumpe, insbesondere Turbomolekularpumpe (111), umfassend:
ein Permanentmagnetlager (183) mit N Ringmagneten (195, 197), die gemäß dem Verfahren nach einem der Ansprüche 9 bis 12 aus einer vorbestimmten Vielzahl M von Ringmagneten (195, 197) derart ausgewählt sind, dass der Magnetlagerfehler und/oder das magnetisches Streufeld des Permanentmagnetlagers (183) eine vorbestimmte Optimierungsbedingung erfüllen.

## Claims

1. An apparatus (700) for assessing a magnetic bearing (183) of a vacuum pump, in particular a turbomolecular pump (111), said magnetic bearing (183) having a plurality of magnetic elements (195, 197) to rotatably support a rotor (149) at a stator,
wherein the apparatus (700) comprises:
a measurement device (710) which is configured to acquire measurement values of the magnetic field strength at a plurality of predetermined positions of a respective one of the plurality of magnetic elements (195, 197), and
an evaluation device (720) which is communicatively connected to the measurement device (710) and which is configured:
to receive, for each of the magnetic elements (195, 197), the measurement values of the magnetic field strength acquired by the measurement device (710),
to determine magnetization properties for each of the magnetic elements (195, 197) based on the measurement values of the magnetic field strength,
to receive predefined geometric data of the magnetic bearing (183),
to determine at least one resulting force, which is exerted by the magnetic elements (195, 197) on the rotor (149), based on the magnetization properties of each of the magnetic elements (195, 197) and based on the predefined geometric data of the magnetic bearing (183), and
to determine and output an assessment of the magnetic bearing (183) based on the resulting force,
**characterized in that**
the evaluation device (720) is further configured to determine the at least one resulting force in dependence on an axial displacement of the rotor (149) with respect to the stator and to assess the magnetic bearing (183) based on the dependence of the resulting force on the axial displacement of the rotor (149) with respect to the stator.

2. An apparatus (700) according to claim 1, wherein
the evaluation unit (710) is further configured:
to form a coefficient matrix which describes the dependence of individual forces, which are exerted by the respective magnetic elements (195, 197) on the rotor (149), on the respective magnetization properties of the individual magnetic elements (195, 197), and
to determine the resulting force by a vectorial addition of the individual forces of the respective magnetic elements (195, 197).

3. An apparatus according to claim 1 or 2, wherein
the evaluation device (710) is further configured to determine and output a magnetic bearing error based on the at least one resulting force and/or to determine and output a magnetic stray field of the magnetic bearing (183) based on the magnetization properties of each of the magnetic elements (195, 197) and based on the predefined geometric data of the magnetic bearing.

4. An apparatus (700) according to claim 3, wherein
the apparatus (700) comprises an optimization device (730) which is configured to vary the predefined geometric data of the magnetic bearing (183) and/or parameters of the magnetic elements (195, 197) such that the magnetic bearing error and/or the magnetic stray field of the magnetic bearing (183) satisfies/satisfy a predetermined optimization condition.

5. An apparatus (700) according to any one of the claims 1 to 4, wherein
the magnetic bearing is configured as a permanent magnet bearing (183) in which the magnetic elements comprise a predefined number of ring magnets (195, 197), and
the measurement device (710) is configured to determine the magnetic field strength along a circumference of every single one of the ring magnets (195, 197) of the magnetic bearing (183).

6. A method of assessing a magnetic bearing (183) of a vacuum pump, in particular a turbomolecular pump (111), said magnetic bearing (183) having a plurality of magnetic elements (195, 197) to rotatably support a rotor (149) at a stator,
wherein the method comprises that:
a) measurement values of the magnetic field strength are acquired at a plurality of predetermined positions of a respective one of the plurality of magnetic elements (195, 197),
b) magnetization properties are determined for each of the magnetic elements (195, 197) based on the measurement values of the magnetic field strength,
c) predefined geometric data of the magnetic bearing (183) are received,
d) at least one resulting force, which is exerted by the magnetic elements (195, 197) on the rotor (149), is determined based on the magnetization properties of each of the magnetic elements (195, 197) and based on the predefined geometric data of the magnetic bearing (183), and
e) an assessment of the magnetic bearing (183) is determined and output based on the resulting force,
**characterized in that**
the at least one resulting force is determined in dependence on an axial displacement of the rotor (149) with respect to the stator, and the magnetic bearing (183) is assessed based on the dependence of the resulting force on the axial displacement of the rotor (149) with respect to the stator.

7. A method according to claim 6, wherein
a coefficient matrix is formed that describes the dependence of individual forces, which are exerted by the respective magnetic elements (195, 197) on the rotor (149), on the respective magnetization properties of the individual magnetic elements (195, 197), and
the resulting force is determined by a vectorial addition of the individual forces of the respective magnetic elements (195, 197).

8. A method according to claim 6 or 7, wherein
a magnetic bearing error is further determined based on the at least one resulting force and/or a magnetic stray field of the magnetic bearing (183) is determined based on the magnetization properties of each of the magnetic elements (195, 197) and based on the predefined geometric data of the magnetic bearing (183).

9. A method according to claim 8, wherein
the predefined geometric data of the magnetic bearing (183) and/or parameters of the magnetic elements are varied such that the magnetic bearing error and/or the magnetic stray field of the magnetic bearing (183) satisfies/satisfy a predetermined optimization condition.

10. A method according to claim 9, wherein
the magnetic bearing is configured as a permanent magnet bearing (183) and the magnetic elements comprise a predefined number N of ring magnets (195, 197),
wherein the varying of the parameters of the magnetic elements (195, 197) comprises that:
a predetermined plurality M of ring magnets (195, 197) is provided that is greater than the predefined number N of ring magnets (195, 197),
a combination of N ring magnets (195, 197) is selected from the predetermined plurality M of the ring magnets (195, 197) for which the magnetic bearing error and/or the magnetic stray field of the magnetic bearing satisfies/satisfy the predetermined optimization condition.

11. A method according to claim 10, wherein,
for the predetermined plurality M of ring magnets (195, 197), every possible combination of N ring magnets (195, 197) is determined to form the magnetic bearing,
for each determined combination of N ring magnets (195, 197), steps a) to e) are performed to determine, for the respective combination, the respective magnetic bearing error based on the respective at least one resulting force and/or to determine a respective magnetic stray field of the magnetic bearing (183) based on the magnetization properties of the N ring magnets (195, 197) of the respective combination and based on the predefined geometric data of the magnetic bearing (183), and
that combination of N ring magnets (195, 197) is selected for which the respective magnetic bearing error and/or the respective magnetic stray field best satisfies/satisfy the predetermined optimization condition.

12. A method according to any one of the claims 9 to 11,
wherein the predetermined optimization condition comprises that the magnetic bearing error and/or the magnetic stray field is/are substantially constant along an axial direction of the magnetic bearing (183),
and/or
wherein the predetermined optimization condition comprises that the respective magnitude of the magnetic bearing error and/or of the magnetic stray field is smaller than a predetermined threshold value.

13. A vacuum pump, in particular a turbomolecular pump (111), comprising:
a permanent magnet bearing (183) comprising N ring magnets (195, 197) which are selected from a predetermined plurality M of ring magnets (195, 197) in accordance with the method according to any one of the claims 9 to 12 such that the magnetic bearing error and/or the magnetic stray field of the permanent magnet bearing (183) satisfies/satisfy a predetermined optimization condition.

## Revendications

1. Dispositif (700) d'évaluation d'un palier magnétique (183) d'une pompe à vide, en particulier d'une pompe turbomoléculaire (111), qui comprend une pluralité d'éléments magnétiques (195, 197) pour supporter de manière rotative un rotor (149) sur un stator,
le dispositif (700) comprenant :
un organe de mesure (710) conçu pour saisir des valeurs de mesure de l'intensité du champ magnétique à plusieurs positions prédéfinies de chacun de la pluralité d'éléments magnétiques (195, 197), et
un organe d'évaluation (720) relié de manière communicative à l'organe de mesure (710) et conçu pour :
recevoir, pour chacun des éléments magnétiques (195, 197), les valeurs de mesure de l'intensité du champ magnétique saisies par l'organe de mesure (710),
déterminer les propriétés d'aimantation pour chacun des éléments magnétiques (195, 197) à l'aide des valeurs de mesure de l'intensité du champ magnétique,
recevoir des données géométriques prédéfinies du palier magnétique (183), déterminer, à l'aide des propriétés d'aimantation de chacun des éléments magnétiques (195, 197) et à l'aide des données géométriques prédéfinies du palier magnétique (183), au moins une force résultante que les éléments magnétiques (195, 197) exercent sur le rotor (149), et
déterminer et émettre une évaluation du palier magnétique (183) à l'aide de la force résultante,
**caractérisé en ce que**
l'organe d'évaluation (710) est en outre conçu pour déterminer ladite au moins une force résultante en fonction d'un déplacement axial du rotor (149) par rapport au stator et pour évaluer le palier magnétique (183) à l'aide de la fonction de la force résultante dépendant du déplacement axial du rotor (149) par rapport au stator.

2. Dispositif (700) selon la revendication 1,
dans lequel l'organe d'évaluation (710) est en outre conçu pour :
former une matrice de coefficients qui décrit la fonction des forces individuelles exercées par les éléments magnétiques respectifs (195, 197) sur le rotor (149) et dépendantes des propriétés d'aimantation respectives des éléments magnétiques individuels (195, 197), et
déterminer la force résultante par une addition vectorielle des forces individuelles des éléments magnétiques respectifs (195, 197).

3. Dispositif (700) selon la revendication 1 ou 2,
dans lequel l'organe d'évaluation (710) est en outre conçu pour déterminer et émettre un défaut du palier magnétique à l'aide de ladite au moins une force résultante et/ou pour déterminer et émettre un champ de dispersion magnétique du palier magnétique (183) à l'aide des propriétés d'aimantation de chacun des éléments magnétiques (195, 197) et à l'aide des données géométriques prédéfinies du palier magnétique.

4. Dispositif (700) selon la revendication 3,
dans lequel le dispositif (700) comprend un organe d'optimisation (730) conçu pour faire varier les données géométriques prédéfinies du palier magnétique (183) et/ou les paramètres des éléments magnétiques (195, 197) de telle sorte que le défaut du palier magnétique et/ou le champ de dispersion magnétique du palier magnétique (183) remplissent une condition d'optimisation prédéfinie.

5. Dispositif (700) selon l'une des revendications 1 à 4,
dans lequel le palier magnétique est conçu comme un palier à aimants permanents (183) dans lequel les éléments magnétiques comprennent un nombre prédéfinie d'aimants annulaires (195, 197), et
l'organe de mesure (710) est conçu pour déterminer l'intensité du champ magnétique le long d'une circonférence de chacun des aimants annulaires (195, 197) du palier magnétique (183).

6. Procédé d'évaluation d'un palier magnétique (183) d'une pompe à vide, en particulier d'une pompe turbomoléculaire (111), qui comprend une pluralité d'éléments magnétiques (195, 197) pour supporter de manière rotative un rotor (149) sur un stator,
le procédé consistant à :
a) saisir des valeurs de mesure de l'intensité du champ magnétique à plusieurs positions prédéfinies de chacun de la pluralité d'éléments magnétiques (195, 197),
b) déterminer les propriétés d'aimantation pour chacun des éléments magnétiques (195, 197) à l'aide des valeurs de mesure de l'intensité du champ magnétique,
c) recevoir des données géométriques prédéfinies du palier magnétique (183),
d) déterminer, à l'aide des propriétés d'aimantation de chacun des éléments magnétiques (195, 197) et à l'aide des données géométriques prédéfinies du palier magnétique (183), au moins une force résultante que les éléments magnétiques (195, 197) exercent sur le rotor (149), et
e) déterminer et émettre une évaluation du palier magnétique (183) à l'aide de la force résultante,
**caractérisé en ce que**
ladite au moins une force résultante est déterminée en fonction d'un déplacement axial du rotor (149) par rapport au stator, et
le palier magnétique (183) est évalué à l'aide de la fonction de la force résultante dépendant du déplacement axial du rotor (149) par rapport au stator.

7. Procédé selon la revendication 6,
dans lequel une matrice de coefficients est formée, laquelle décrit la fonction des forces individuelles exercées par les éléments magnétiques respectifs (195, 197) sur le rotor (149) et dépendantes des propriétés d'aimantation respectives des éléments magnétiques individuels (195, 197), et
la force résultante est déterminée par une addition vectorielle des forces individuelles des éléments magnétiques respectifs (195, 197).

8. Procédé selon la revendication 6 ou 7,
dans lequel un défaut du palier magnétique est en outre déterminé à l'aide de ladite au moins une force résultante, et/ou un champ de dispersion magnétique du palier magnétique (183) est déterminé à l'aide des propriétés d'aimantation de chacun des éléments magnétiques (195, 197) et à l'aide des données géométriques prédéfinies du palier magnétique (183).

9. Procédé selon la revendication 8,
dans lequel les données géométriques prédéfinies du palier magnétique (183) et/ou les paramètres des éléments magnétiques sont variés de telle sorte que le défaut du palier magnétique et/ou le champ de dispersion magnétique du palier magnétique (183) remplissent une condition d'optimisation prédéfinie.

10. Procédé selon la revendication 9,
dans lequel le palier magnétique est conçu comme un palier à aimants permanents (183), et les éléments magnétiques comprennent un nombre pré-défini N d'aimants annulaires (195, 197),
la variation des paramètres des éléments magnétiques (195, 197) consiste à :
fournir une pluralité prédéfinie M d'aimants annulaires (195, 197), qui est supérieure au nombre prédéfinie N d'aimants annulaires (195, 197),
sélectionner une combinaison de N aimants annulaires (195, 197) parmi la pluralité prédéfinie M d'aimants annulaires (195, 197), pour laquelle le défaut du palier magnétique et/ou le champ de dispersion magnétique du palier magnétique remplissent la condition d'optimisation prédéfinie.

11. Procédé selon la revendication 10,
dans lequel, pour la pluralité prédéfinie M d'aimants annulaires (195, 197), chaque combinaison possible de N aimants annulaires (195, 197) pour la formation du palier magnétique est déterminée,
pour chaque combinaison déterminée de N aimants annulaires (195, 197), les étapes a) à e) sont exécutées afin de déterminer pour la combinaison respective le défaut respectif du palier magnétique à l'aide de ladite au moins une force résultante respective et/ou afin de déterminer un champ de dispersion magnétique respectif du palier magnétique (183) à l'aide des propriétés d'aimantation des N aimants annulaires (195, 197) de la combinaison respective et à l'aide des données géométriques prédéfinies du palier magnétique (183), et
la combinaison de N aimants annulaires (195, 197) est sélectionnée, pour laquelle le défaut respectif du palier magnétique et/ou le champ de dispersion magnétique respectif remplissent le mieux la condition d'optimisation prédéfinie.

12. Procédé selon l'une des revendications 9 à 11,
dans lequel la condition d'optimisation prédéfinie comprend le fait que le défaut du palier magnétique et/ou le champ de dispersion magnétique sont sensiblement constants le long d'une direction axiale du palier magnétique (183), et/ou
la condition d'optimisation prédéfinie comprend le fait que la valeur absolue respective du défaut du palier magnétique et/ou du champ de dispersion magnétique est inférieure à une valeur de seuil prédéfinie.

13. Pompe à vide, en particulier pompe turbomoléculaire (111), comprenant : un palier à aimants permanents (183) comportant N aimants annulaires (195, 197) qui sont sélectionnés parmi une pluralité prédéfinie M d'aimants annulaires (195, 197) par le procédé selon l'une des revendications 9 à 12, de telle sorte que le défaut du palier magnétique et/ou le champ de dispersion magnétique du palier à aimants permanents (183) remplissent une condition d'optimisation prédéfinie.
